(19)

Europäisches
Patentamt
European
Patent Office
Office européen
des brevets

(11) **EP 3 572 804 A1**

(12) **EUROPEAN PATENT APPLICATION**

(43) Date of publication:
**27.11.2019 Bulletin 2019/48**

(21) Application number: **19176846.4**

(22) Date of filing: **27.05.2019**

(51) Int Cl.:
*G01N 24/08* (2006.01)   *G01N 24/10* (2006.01)
*G01N 24/12* (2006.01)   *G01R 33/28* (2006.01)
*G01R 33/34* (2006.01)   *G01R 33/565* (2006.01)

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **25.05.2018   IT 201800005737**

(71) Applicant: **Consiglio Nazionale Delle Ricerche - CNR**
**00185 Roma (IT)**

(72) Inventor: **ANNINO, Giuseppe**
**50019 Sesto Fiorentino (IT)**

(74) Representative: **Celestino, Marco**
**ABM Agenzia Brevetti & Marchi**
**Viale Giovanni Pisano 31**
**56123 Pisa (IT)**

(54) **NMR PROBE HEAD**

(57)   A probe head (30,50,60,70,80,90,100,101,130,130,131,150,151, 160,180,190,200) for NMR techniques comprises an RF-coil (10) equipped with a first conductor (11) and with a second conductor (12,191) facing one another and arranged at a predetermined distance (L) from one another, so as to define a measurement zone (13) to each other where a sample (39) can be arranged ; a connection conductor (16) connecting the end portions of the first and of second conductors (11,12), the first conductor (11), the connection conductor (16) and the second conductor (12) made of a first material having a first magnetic susceptibility ($\chi_{n,ml}$) ; an RF circuit (15) connected through an electric connection means (14) to the first and to the second conductor (11,12) opposite to the connection conductor (16), so as to create a path (17) for an RF current ($I_{RF}$). According to the invention, the first conductor (11) comprises linear conductor elements (9) arranged at such a mutual distance that the first conductor (11) is transparent to a microwave radiation having a predetermined wavelength; the first and the second conductors (11,12) include extensions (37,38,87,88,89,97,98,99,107,109,192,194, 195) made of a second material that has a second magnetic susceptibility ($\chi_{m,mll}$); and the side extension have a predetermined mass that are arranged in such a way to compensate an effect of distortion, i.e. non-uniformity, of the magnetic field in the measurement zone (13).

**Fig. 3B**

**Description**

Field of the invention

The present invention relates to a probe head structure for performing NMR measurements at high spectral resolution on liquid and solid samples. The proposed probe head structure is suitable for conventional NMR measurements, which can be based on such techniques as Magic Angle Spinning (MAS) or Magnetic Resonance Imaging (MRI), possibly in combination with DNP enhancement (DNP-NMR, DNP-MRI, and DNP-MAS techniques).

Prior art - Technical problems

In the last decades, the NMR techniques have had a huge impact on our daily life, thanks to both to their diagnostic capabilities in health analysis, which is a particular feature of MRI techniques, and to their ability to reveal the conformational details of complex biomolecules as proteins. As well known, in the NMR techniques a sample is subjected to a static magnetic field produced by a main magnet, and to another magnetic field that is produced by radiofrequency (RF) currents and that causes a measurable spin precession of the nuclei of the sample atoms.

In order to improve the sensitivity of the NMR techniques, DNP (Dynamic Nuclear Polarization) techniques have been introduced in which the nuclear spin polarization is increases with respect to the values corresponding to a thermodynamic equilibrium. In the DNP techniques, the partial saturation of the Electron Paramagnetic Resonance (EPR) transitions of paramagnetic species present in the sample increases the nuclear spin polarization by orders of magnitude. The saturation of the EPR transitions is usually obtained by intense microwave irradiation of the sample.

Spectral resolution is a concern in NMR techniques, regardless whether DNP is carried out. This consists in the capacity of distinguishing nuclear spin precession frequencies even if they slightly differ from one another. In fact, the detection of such differences can provide very detailed microscopic data. An indispensable requirement to achieve a high spectral resolution is a high spatial homogeneity, i.e. uniformity, of the static magnetic field in the measurement region of the probe head, where the sample to be characterized is arranged.

The spectral resolution that can be obtained with the present NMR techniques is strongly affected by the static magnetic field distortion, i.e. by non-uniformity of the static magnetic field. This depends in turn on the magnetic susceptibility of the components and of the parts of the probe head, of a possible sample holder and of the sample itself. In other words, the spectral resolution is limited by an unbalanced distribution of the magnetic susceptibilities. In fact, the static magnetic susceptibility $\chi_m$ of most materials is about $10^{-5}$ or higher in the SI unit system. Such a susceptibility value can lead to a relative inhomogeneity, i.e. to a relative distortion, of the static magnetic field, defined as the difference between a maximum value and a minimum value of the magnitude of the B vector, of about 10-5. In the NMR measurements, a spectral resolution of 10-6 is considered a medium resolution. In order to obtain a high spectral resolution, static field homogeneity of the order of 10-8 or better should be achieved. When the static magnetic field distortion occurs with a broadening of the shape of the magnetic resonance lines, this effect is referred to as "susceptibility broadening".

The resolution loss related to the susceptibility broadening introduced by the probe head can be partially obviated using secondary shim coils, which generate a spatially variable magnetic field with the aim to compensate the effects of the probe head on the static field homogeneity. At the beginning of medium and high-resolution NMR measurements, an automatic shimming procedure adjusts the local static field according to the observed NMR lineshape of a given line. However, such a procedure does not always reach the desired level of field homogeneity, the result depending on the number of shim coils, the complexity of the local magnetic field dependence, the search algorithm. Typically, it fails when the static field distortion is too high or when the local field variation is too rapid [44b]. In any case, it is a lengthy procedure, which often prevents high-resolution measurements and also real-time medium resolution measurements.

The problem a poor spectral resolution is particularly felt in those applications including such steps as:

- dynamic nuclear polarization (DNP) at a low sample temperature lower, i.e. at such a temperature at which the sample is in the solid state and is characterized by relatively wide NMR spectra and, subsequently,
- measurement at a measurement temperature that is higher than the polarization temperature, at which the sample is in the liquid state and is characterized by relatively narrow NMR spectra,

these techniques being referred to as temperature-jump DNP techniques, or melting DNP techniques, if sample melting occurs during the sample-heating step from the polarization temperature to the measurement temperature.

At present, no high-resolution probe heads are available that allow both the low-temperature polarization step and the high-temperature measurement step, as well as the sample-heating step to be carried out on a same apparatus (i.e. in situ). For this reason, the sample must be quickly displaced from a polarization site to a high-resolution measuring site, for instance, from a first to a second spectrometer, or from a first to a second head of a same spectrometer. This is disadvantageous, since two apparatuses or a complex apparatus are/is required to perform such high-resolution measurements, which increases the investment and maintenance costs, and causes discomfort to the operators. Moreover, a spin polarization loss occurs during such a sample displacement, which decreases the measurement sensitivity theoretically achievable at a given polarization level.

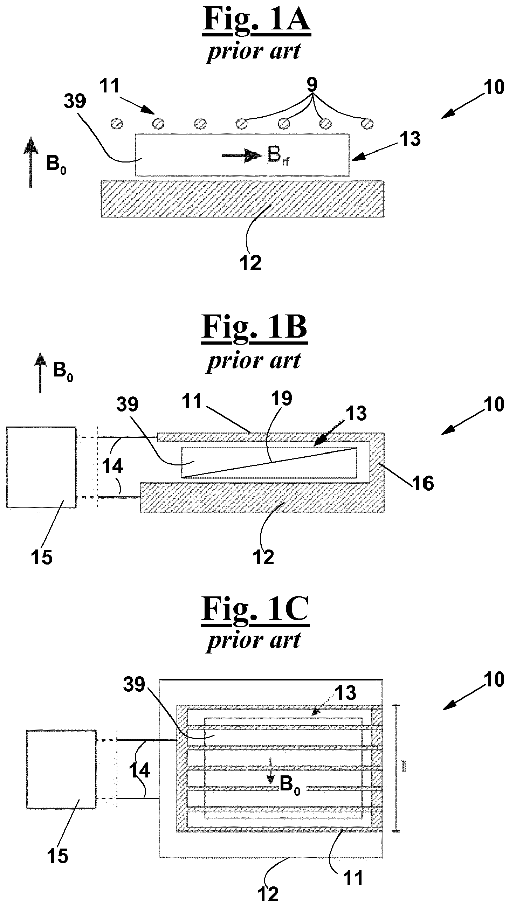

WO 2013/000964, the description of which is incorporated by reference herein, discloses a probe head for NMR and DNP-NMR measurements. Figs. 1A-1C show the basic structure of this probe head, including an RF-coil 10 that can be used for both exciting the nuclear spin transitions and transducing i.e. converting a part of the energy of the precessing spins into an RF signal, as usual in the NMR techniques.

RF-coil 10 has a substantially U-shaped cross section, which defines a sample-measurement zone 13. RF-coil 10 can be made of one or more materials, and comprises a conductive grid 11 made of linear conductor elements 9 and a conductive plate 12. A connection conductor 16 of length L electrically connects respective end portions of grid 11 and of plate 12. Moreover, an electric connection 14 is provided between grid 11 and plate 12, on one hand, and respective terminals of an RF circuit 15, on the other end. RF-coil 10 is very effective in exciting the nuclear spin transitions and in detecting the corresponding precession signal, due to the quasi-closed shape of the RF currents circulating in the coil, and to the proximity of these currents to sample-measurement zone 13.

Grid 11 is configured to be substantially transparent to microwaves of appropriate polarization, to which the sample is exposed in a DNP-NMR procedure, whereas plate 12 serves as a mirror for the microwaves. This way, microwaves can irradiate the sample without being substantially reflected or distorted by grid 11. This improves both microwave polarization efficiency and microwave polarization control, which in turn improves DNP-NMR measurement sensitivity with respect to the prior art.

The RF-coil is normally made of such a high-electric conductivity material as copper, which has a magnetic susceptibility $\chi_{m,Cu} = -0.965 \times 10^{-5}$.

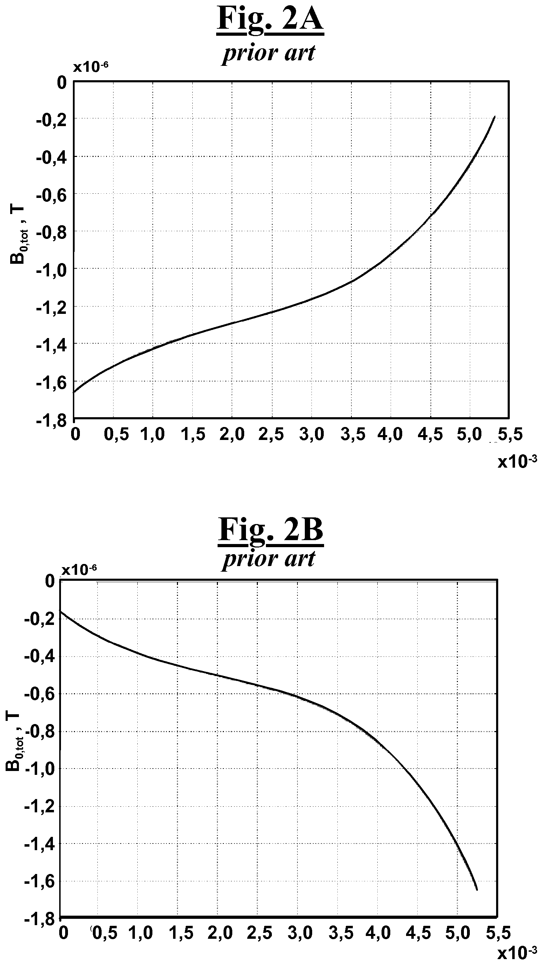

The plot of Fig. 2A shows how overall static magnetic field $B_{0,tot}$ varies along the oblique line 19 of Fig. 1B, which connects the points of maximum magnetic field variation in sample-measurement zone 13. In particular, the plot relates to the $B_{0,tot}$ component that has the same direction as the external magnetic field, which in this case is orthogonal to the probe head and is equal to 1 Tesla (T). The maximum relative variation, in this case, is about $1.45 \times 10^{-6}$.

Instead, Fig. 2B is a plot showing how magnetic field $B_{0,tot}$ varies along oblique line 19 of RF-coil 10 if the external static external magnetic field is parallel to conductive grid 11 and to conductive plate 12. In this case, the maximum relative variation of the component of $B_{0,tot}$ in sample-measurement zone 13 is about $1.5 \times 10^{-6}$.

More in detail, the data of Figs. 2A and 2B relate to an RF-coil 10 in which conductive plate 12 is obtained from a 7.7 mm side and 2 mm height block of copper, the side and the height of conductive grid 11 are 6.7 mm and 0.1 mm, respectively, and the side and the height of connection conductor 16 are 0.3 mm and 2.4 mm, respectively. The side and the height of sample-measurement zone 13 are 5 mm and 2 mm, respectively, its distance from both conductive plate 12 and conductive grid 11 is 0.2 mm, and its distance from connection conductor 16 is 0.4 mm. The depth of the structure is far larger than the other dimensions, and grid 11, comprising linear conductor elements 9, can be approximated by a continuous plate.

A drawback of the above prior art NMR and DNP-NMR probe heads, among which the probe head of WO 2013/000964, is a relatively low spectral resolution.

EP1193505 discloses low-temperature (cryogenic) NMR RF coils including composite multi-layered structures including an internal normal metal layer clad on both sides by external high-purity annealed aluminum layers. The magnetic susceptibilities of the internal and external layers are opposite in sign, and the layer thicknesses are selected so that the composite structure has a net magnetic susceptibility equal to the magnetic susceptibility of its surroundings (vacuum or support material). The internal layer can have a higher resistivity and magnetoresistance than the external layers.

Summary of the invention

It is therefore a feature of the present invention to provide an NMR probe head structure that can enable NMR techniques with high spectral resolution.

It is also a feature of the invention to provide a high-resolution NMR probe head structure by which shimming procedures are not strictly necessary to correct the measurements, or by which faster and more accurate shimming procedures can be carried out.

It is also a feature of the invention to provide an NMR probe head structure by which high sensitivity measurements and high spectral resolution measurements are possible at once, in particular an NMR probe head including an RF-coil of the type described in WO 2013/000964.

It is a particular feature of the invention to provide such a probe head that enables performing in situ DNP-NMR measurements at a temperature higher than the temperature at which the nuclear spin polarization is carried out, in which case, in particular, the temperature of the sample is quickly increased.

It is also a feature of the invention to provide an NMR probe head that makes it possible to modify a spectrometer by changing the probe head in a simple way, in order to improve at least the spectral resolution of the spectrometer, so that the latter, in particular, can perform *in situ* medium- and high-resolution DNP-NMR measurements.

These and other objects are achieved by a probe head according to claim 1. Advantageous exemplary embodiments of the probe head are defined by the dependent claims.

According to the invention, a probe head for NMR techniques comprises:

- an RF-coil having a first conductor and a second conductor facing one another and arranged at a predetermined distance from one another, so as to define a measurement zone therebetween intended for arranging a sample therein;
- a connection conductor electrically connecting respective end portions of the first conductor and of the second conductor,
- the first conductor, the connection conductor and the second conductor made of a material having a first magnetic susceptibility;
- an RF circuit connected through an electric connection means to the first conductor and to the second conductor opposite to the connection conductor, so that the first conductor, the connection conductor and the second conductor form a path for an RF current,

wherein the main feature of the invention is that

- the first conductor comprises linear conductor elements arranged at such a mutual distance that the first conductor is transparent to a microwave radiation having a predetermined wavelength;
- the first conductor and the second conductor have lateral extensions made of a material having a second magnetic susceptibility;
- the lateral extensions have a predetermined mass arranged to compensate a magnetic field distortion effect in the measurement zone.

In case of DNP-NMR, DNP-MRI, and DNP-MAS applications, the proposed invention allows a high polarization efficiency and low polarization losses in the subsequent heating of the sample, as well as high spectral resolution.

In some exemplary embodiments, the probe heads according to the invention are configured to perform NMR measurements at high spectral resolution, which is compatible with a fast and large temperature variation of the sample.

In particular, the invention solves or in any case remarkably reduces the problem of the static magnetic field distortion in the measurement zone, which is caused by some components and parts of the probe heads employed in NMR, MRI, MAS, DNP-NMR, DNP-MRI, and DNP-MAS techniques. This goal is reached by arranging an appropriate combination of elements having predetermined magnetic susceptibilities proximate to the RF-coil of the probe head, i.e., by providing extensions of the conductors. This way, an improvement of the spectral resolution of the measurements is obtained. Moreover, the invention enables medium- and high-resolution magnetic resonance techniques, either without having recourse to shimming to correct the measurements or, if shimming is used, this is simpler and faster to perform than before the invention.

The appropriate combination or distribution of elements having predetermined magnetic susceptibilities can be selected among:

- a uniform-susceptibility combination, i.e. one in which elements having equal or similar magnetic susceptibilities are arranged proximate to the RF-coil, in such a way to create a substantially uniform-susceptibility region in the measurement zone; the materials of these elements can be insulating or conductive materials, homogeneous or inhomogeneous materials, nanostructured materials, doped materials, alloys, solutions, mixtures and the like;
- a balanced-susceptibility combination, i.e. one in which elements having predetermined susceptibilities and shapes are substantially symmetrically arranged proximate to the RF-coil, so that the contributions of the respective susceptibilities of these elements balance to each other in the measurement zone;
- a compensated-susceptibility combination, i.e. one in which elements having different susceptibilities are arranged proximate to the RF-coil, in such a way to create a region of approximately no magnetic susceptibility contribution in the measurement zone, in particular these elements have susceptibilities of sign opposite to the RF-coil components.

In one exemplary embodiment, the absolute values of the second magnetic susceptibility $\chi_{m,mII}$ and of the first magnetic susceptibility $\chi_{m,ml}$ differ by less than a predetermined difference value.

In one exemplary embodiment, the first conductor or the second conductor extend along the direction of a first lateral dimension I and at least one of the lateral extensions has a second lateral dimension d wherein the second lateral dimension d and the first lateral dimension I have a ratio higher than a predetermined value.

In one exemplary embodiment, the lateral extensions have substantially the same thickness $t_1$, $t_2$.

In one exemplary embodiment, at least one of the lateral extensions has a thicknesses $t_1$,$t_2$ substantially the same as the thickness $t_2$ of the second conductor.

In one exemplary embodiment, the first material is copper and the second material is Polyethylene Terephthalate.

In one exemplary embodiment, the probe head also comprises a further magnetic balancing extension proximate to the connection conductor, wherein the further extension is made of a material III having a third magnetic susceptibility $\chi_{m,mIII}$ of opposite sign with respect to the first susceptibility $\chi_{m,mI}$ of material I, and is arranged to compensate a magnetic field distortion effect due to the connection conductor.

In one exemplary embodiment, the further magnetic balancing extension is a magnetic balancing plate arranged in contact with the connection conductor.

In one exemplary embodiment, the connection conductor and the magnetic balancing plate have respective thicknesses $d_I$, $d_{III}$ selected so as to satisfy the relationship:

$$d_I |\chi_{m,mI}| = d_{III} |\chi_{m,mIII}|.$$

In one exemplary embodiment, the magnetic balancing plate has an at least in part curvilinear cross section, wherein the magnetic balancing plate has a first flat face oriented towards the connection conductor and a concave second side, opposite to the first face, with a higher thickness in a proximity of the first and/or of the second conductor.

In one exemplary embodiment, the lateral extensions of the first conductor and of the second conductor are made of materials II, II' of respective magnetic susceptibilities $\chi_{m,mII}$, $\chi_{m,mII'}$ and have respective thicknesses $t_1$, $t_2$ selected so as to satisfy the relationship:

$$t_1\ \chi_{m,mII} = t_2\ \chi_{m,mII'}.$$

In one exemplary embodiment, the first conductor and the second conductor are made of materials I, Ib of respective magnetic susceptibilities $\chi_{m,mI}$, $\chi_{m,mIb}$, and wherein the lateral extensions of the first conductor and of the second conductor are made of materials II, IIb of respective magnetic susceptibilities $\chi_{m,mII}$, $\chi_{m,mIIb}$ and have respective thicknesses $t_1$, $t_2$ selected so as to satisfy the relationship:

$$t_1\ \chi_{m,mII} = t_2\ \chi_{m,mIIb}.$$

In one exemplary embodiment, the first conductor and the second conductor have respective pluralities $N_1$, $N_2$ of lateral extensions in the form of layers made of respective materials having respective predetermined magnetic susceptibilities $\chi_{m,1,i}$; $\chi_{m,2,I,I} = 1...N_1$; $i = 1...N_2$,

In one exemplary embodiment, the layers have respective thicknesses $t_{1,i}$; $t_{2,I,I} = 1...m_1$; $i = 1...m_2$ selected so as to satisfy the relationship:

$$t_{1,1}\chi_{m,1,1} + t_{1,2}\chi_{m,1,2} +... = t_{2,1}\chi_{m,2,1} + t_{2,2}\chi_{m,2,2} +...$$

In one exemplary embodiment, an extension layer of the second conductor is arranged along the outer face of the second conductor and of the extension of the second conductor, the extension layer made of a material IV having a predetermined magnetic susceptibility $\chi_{m,mIV}$ of opposite sign with respect to the magnetic susceptibilities $\chi_{m,mI}$ of the first conductor and of the second conductor.

In one exemplary embodiment, the extensions of the first conductor and of the second conductor and the further extension have respective thicknesses $t_1$, $t_{2,1}$, $t_{2,2}$ selected so as to satisfy the relationship:

$$t_1\ \chi_{m,mII} = t_{2,1}\ \chi_{m,mI} + t_{2,2}\ \chi_{m,mIV} = t_{2,1}\ \chi_{m,mI} - t_{2,2}\ |\chi_{m,mIV}|.$$

In one exemplary embodiment, the extension of the first conductor is made of a material V having opposite sign with respect to the first material I of the RF-coil.

In one exemplary embodiment, the extensions of the first conductor and of the second conductor and the further extension have respective thicknesses $t_1$, $t_{2,1}$, $t_{2,2}$ selected so as to satisfy the relationship:

$$t_1 \chi_{m,mV} = t_{2,1} \chi_{m,mI} + t_{2,2} \chi_{m,mIV} = t_{2,1} \chi_{m,mI} - t_{2,2} |\chi_{m,mIV}|.$$

In one exemplary embodiment, the probe head also comprises a spacing element made of a material having a magnetic susceptibility whose absolute value differs from the absolute value of the first magnetic susceptibility $\chi_{m,mI}$ by less than a predetermined difference value, in particular the spacing element is made of the second material II.

In one exemplary embodiment, the extension of the first conductor is made of a material selected among PTFE, single-crystal quartz, sapphire, high-resistivity silicon.

In one exemplary embodiment, the lateral extensions of the first conductor comprise linear conductor elements arranged at such a mutual distance that the lateral extensions are transparent to the microwave radiation.

In one exemplary embodiment, the extension of the first conductor has substantially the same thickness $t_2$ as the first conductor.

In one exemplary embodiment, the extension of the first conductor is made of a material of magnetic susceptibility of opposite sign with respect to the material of the linear conductor elements.

In one exemplary embodiment, the extension of the second conductor comprises only the extension layer.

In one exemplary embodiment, the probe head also comprises a sample holder wherein two layers are provided connected to each other by connection elements transversally arranged with respect to the layers, wherein the layers and the connection elements have such a thickness that the sample holder fits between the first conductor and the second conductor, wherein the layers are made of materials having a predetermined magnetic susceptibility, so as to obtain a balanced contribution to the static magnetic field Bo in the measurement zone.

In one exemplary embodiment, the layers and the connection elements define a plurality of chambers in the sample holder.

In one exemplary embodiment, at least one of the chambers is configured to receive a liquid sample.

In one exemplary embodiment, at least one of the chambers of the sample holder is configured to receive an amount of a material having a magnetic susceptibility that differs from the magnetic susceptibility of the sample by less than a predetermined difference value.

In one exemplary embodiment, the material is a solvent for the sample, and the sample holder comprises flow passages through the separation elements that are configured to selectively bring the solvent into contact with the sample.

In one exemplary embodiment, the extension in the form of layer has a thickness shorter than one tenth of the wavelength $\lambda_{mw}$.

In one exemplary embodiment, the plurality $N_1$ of lateral extensions in the form of layers of the first conductor, the layers having respective thicknesses $t_{1,j}$ and respective refraction indexes $n_{1,j}$ with respect to the microwave radiation has an overall optical thickness

$$\tau_{1,opt} = \tau_{w/s} + t_{1,1}n_{1,1} + t_{1,2}n_{1,2} + \ldots = \tau_{w/s} + \sum_{j=1}^{N} t_{1,j}n_{1,j} \, ,$$

where $\tau_{w/s}$ is the contribution of the propagation through the linear conductor elements of the first conductor, wherein $\tau_{1,opt}$ is about an integer multiple of one half of the wavelength $\lambda_{mw}$.

In an exemplary embodiment of the invention, the probe head comprises an electric heating means for increasing the temperature of the sample from a polarization temperature of a DNP-NMR technique to a measurement temperature and/or to a temperature of interest in a predetermined heating time. This embodiment allows simplifying and reducing the costs of DNP-NMR techniques including an intermediate heating of the sample from the polarization temperature to the measurement temperature, in particular, of DNP-NMR techniques including melting the sample between the polarization step and the measurement step.

The electric heating means can comprise an electrically conductive layer for a heating electric current that is an intermediate layer of at least one multi-layered element of the plurality of elements having a predetermined magnetic susceptibility, and serving as an extension of the conductor of the coil. As an alternative, the heating means can be provided by the second conductor of the RF-coil, which is associated to a means for supplying the heating electric current to this conductor.

For example, the second conductor may have an anisotropic electric conductivity having different values along different electric current propagation directions, and the electric connection and supply means of the second conductor are configured to supply the RF current and the heating current along these different propagation directions, in particular, according to mutually-orthogonal propagation directions.

Brief description of the drawings

The invention will be now shown with the description of exemplary embodiments of the probe head according to the invention, exemplifying but not limitative, with reference to the attached drawings, in which the same reference characters designate the same or similar parts, throughout the figures of which:

- Figs. 1A-1C are front, side and top plan diagrammatical views, respectively, of a flat RF-coil according to the prior art;
- Figs. 2A and 2B are plots showing how the component of magnetic field Bo according to the external static field direction varies along the diagonal line of the measurement zone of the flat RF-coil of Figs. 1A-1C, the external static field being perpendicular or parallel, respectively, to the first and second conductors of the coil;
- Figs. 3A-3C are front, side and top plan diagrammatical views, respectively, of a probe head structure according to an exemplary embodiment of the invention, in which side elements having predetermined magnetic susceptibilities are provided so as to balance the magnetic susceptibility contribution of a flat RF-coil;
- Fig. 4 is a plot showing how the component of magnetic field Bo according to the external static field direction varies along the diagonal line of the measurement zone in the structure of Figs. 3A-3C;
- Fig. 5A is a diagrammatical side view of a probe head structure according to an exemplary embodiment of the invention, that is similar to the structure of Figs. 3A-3C, and in which a further element having a predetermined magnetic susceptibility is provided so as to compensate the magnetic susceptibility contribution of the connection conductor between the portions of the RF-coil;
- Fig. 5B is a plot showing how the component of magnetic field Bo according to the external static field direction varies along the diagonal line of the measurement zone in the structure of Fig. 5A;
- Fig. 6A is a diagrammatical side view of a probe head structure, according to an exemplary embodiment of the invention, similar to the structure of Fig. 5A, in which the further element having a predetermined magnetic susceptibility exposes a curved surface;
- Fig. 6B is a plot showing how the component of magnetic field Bo according to the external static field direction varies along the diagonal line of the measurement zone in the structure of Fig. 6A;
- Fig. 7A is a diagrammatical side view of a probe head structure, according to an exemplary embodiment of the invention, in which the first conductor and the second conductor of the coil are made of materials of different magnetic susceptibilities, and have different thicknesses;
- Fig. 7B is a plot showing how the component of magnetic field Bo according to the external static field direction varies along the diagonal line of the measurement zone in the structure of Fig. 7A;
- Fig. 8A is a diagrammatical side view of a probe head structure, according to an exemplary embodiment of the invention, that is similar to the structure of Fig. 6A, in which the first conductor of the RF-coil has a lower thickness, and in which a partial compensation layer is provided so as to reduce the magnetic susceptibility contribution of the lower portions of the probe head;
- Fig. 8B is a plot showing how the component of magnetic field Bo according to the external static field direction varies along the diagonal line of the measurement zone in the structure of Fig. 8A;
- Fig. 9A is a diagrammatical side view of a probe head structure, according to an exemplary embodiment of the invention, that is similar to the structure of Fig.8A, apart from the material of the first conductor;
- Fig. 9B is a plot showing how the component of magnetic field Bo according to the external static field direction varies along the diagonal line of the measurement zone in the structure of Fig. 9A;
- Figs. 10A-B are diagrammatical side views of probe head structures, according to exemplary embodiments of the invention, in which the magnetic susceptibilities of the first and of the second conductors are compensate by elements made of materials having predetermined and opposite magnetic susceptibilities;
- Fig. 11A shows the probe head structure of Fig. 9 under an external static field that is parallel to the first and second conductors;
- Fig. 11B is a plot showing how the component of magnetic field Bo according to the external static field direction varies along the diagonal line of the measurement zone in the structure of Fig. 11A;
- Figs. 12A-B are top-plan diagrammatical views of two probe head structures, according to further exemplary embodiments of the invention, in which the connection conductor of the RF-coil of Fig. 1A-C is arranged at a magnetic non-influence distance from the measurement zone;
- Fig. 13 is an diagrammatical side view of an RF-coil of the type shown in Fig. 1B, comprising a mechanical stiffening element, for a probe head structure according to an embodiment of the invention;
- Figs. 14A-B are top-plan views of probe head structures, according to further exemplary embodiments of the invention, in which elements having predetermined magnetic susceptibilities are provided so as to compensate the effects of the stiffening element of Fig. 13 on the magnetic susceptibility on the measurement zone;
- Figs. 14C-D are side and top plan diagrammatical views, respectively, of a probe head structure, according to an embodiment of the invention, based on the probe head structures of Figs. 9 and 14, in which a sample holder and a sample are shown;

- Figs. 14E-F are side and top plan diagrammatical views, respectively, of a probe head structure, according to an exemplary embodiment of the invention, that is similar to the probe head structure of Fig. 14C, in which the fraction of volume active is increased by replacing a portion thereof with a material having a similar magnetic susceptibility;
- Figs. 15A-C are front, side and top-plan diagrammatical views, respectively, of the RF-coil of Fig. 1, in which the sample is being irradiated with microwaves;
- Fig. 16 is a diagrammatical front view of a probe head structure, according to an exemplary embodiment of the invention, including a multi-layered modification of the RF-coil of Fig. 1, in which the portions irradiated with microwaves are highlighted;
- Fig. 17 is a diagrammatical front view of a first probe head structure including a multi-layered RF-coil like the structure of Fig. 16;
- Figs. 18A-B are diagrammatical front and top plan views, respectively, of a second probe head structure a multi-layered RF-coil like the structure of Fig. 16.

## Description of exemplary embodiments of the invention

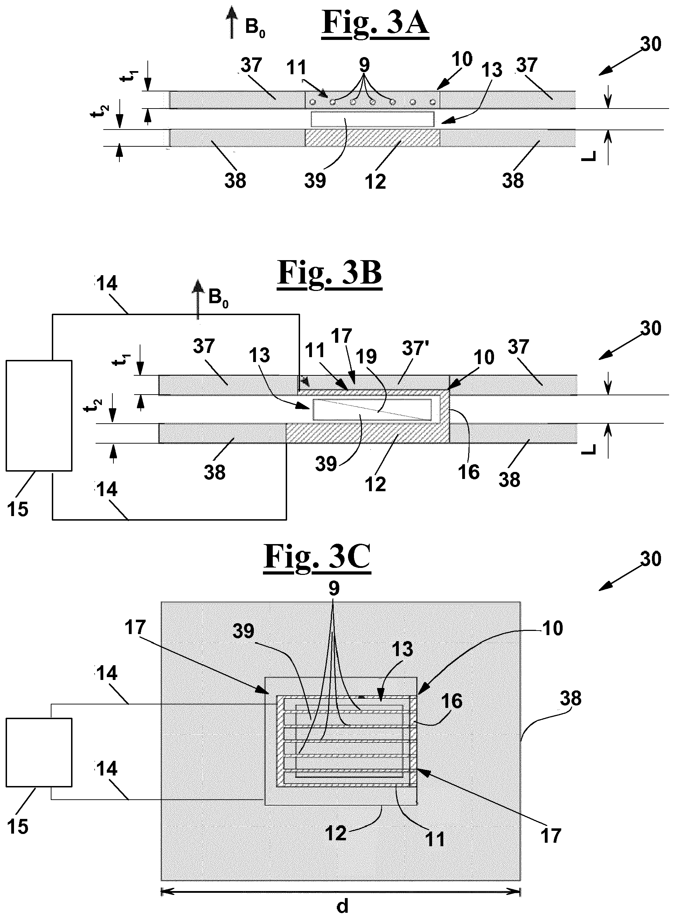

Figs. 3A-3C show a probe head structure 30 according to an exemplary embodiment of the present invention, comprising RF-coil 10 of Figs. 1A-1C, made of a material I of magnetic susceptibility $\chi_{m,mI}$. As described hereinafter, RF-coil 10 can comprise more than one material. A sample 39 is diagrammatically shown in measurement zone 13. In particular, in Fig. 3A shows a first conductor 11 comprising conductor elements 9 that can be arranged to form a grid.

In order to balance the effects of RF-coil 10 on susceptibility in measurement zone 13, according to the invention, probe head structure 30 also comprises side elements 37,38 having predetermined magnetic susceptibilities made of a material II of magnetic susceptibility $\chi_{m,mII}$ close to $\chi_{m,mI}$, in particular such that the difference ($|\chi_{m,mII}| - |\chi_{m,mI}|$) is less than a predetermined difference value. Elements 37,38 are adjacent to first conductor 11 and to second conductor 12, respectively, of RF-coil 10. In Fig. 3B, as a modification of the present embodiment, an element 37' of a different, or the same material as side element 37, is arranged on the first conductor 11 instead of beside it.

In this exemplary embodiment, side elements 37,38 having predetermined magnetic susceptibilities preferably have a lateral dimension d (Fig. 3C) longer than lateral dimension I of RF-coil 10. This way, the effect of the external shape of elements 37,38 on homogeneity of static field Bo in measurement zone 13 can be maintained at a negligible value. The thicknesses $t_1$, $t_2$ of side elements 37,38 having predetermined magnetic susceptibilities can be substantially equal to each other and equal to the thickness t of second conductor 12 of RF-coil 10. For the sake of simplicity, the details of electric connection 14 with RF circuit 15 are not shown in figures 3A-3C.

Material II can be an insulating material or a conductive material, a homogeneous material or a heterogeneous material, a material comprising nanostructures, a doped material, a material comprising an alloy, a material comprising a solid solution of different materials, and the like.

Preferably, material II is selected so that it cannot absorb and/or not distort the RF radiation emitted by RF-coil 10 and by sample 39, in particular it is a low rf loss and/or insulating material, at least when arranged in a region of space subject to a relevant RF field.

Probe head 30 of Fig. 3C has a square shape, but it can have any shape, such as a circular shape, provided it is wide enough, as anticipated.

Side element 37 having a predetermined magnetic susceptibility itself, which is adjacent to first conductor 11, can comprise linear conductor elements, not shown. Side element 37 can also balance, due to symmetry reasons, the magnetic susceptibility contribution of second conductor 12. The latter is laterally extended by material I or material II, in order to reduce the effects of its own edges on homogeneity of static field Bo in measurement zone 13. These effects can be detected when static field Bo, which can have any direction, is orthogonal to first and second conductors 11,12 of RF-coil 10.

When first conductor 11 is surrounded by a material II of similar magnetic susceptibility, it has so-called balancing effects on the static magnetic field that cannot be distinguished from the effects produced by material II, as the simulations confirm. Therefore, first conductor 11 of RF-coil 10 can be properly approximated by a continuous plate.

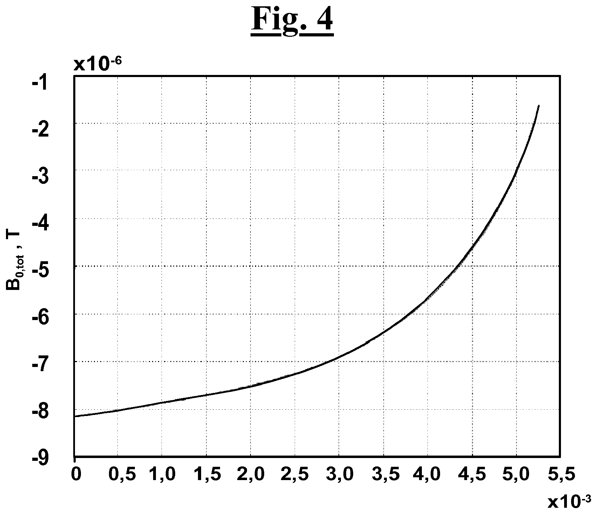

Fig. 4 shows the distribution of static magnetic field Bo in measurement zone 13 of probe head 30 of Fig. 3A-C, along line 19 connecting the points of maximum variation of static magnetic field Bo in sample-measurement zone 13 (Fig. 3B).

The data relate to an RF-coil 10 as described when referring to Fig. 2A, to which side PTFE elements 37,38 of size $t_1 = t_2 = 2$ mm and d = 36 mm have been added. The magnetic susceptibility of PTFE, as material II, is $\chi_{m,mII} = \chi_{m,PTFE} = -1.05 \times 10^{-5}$.

In this exemplary embodiment, the maximum inhomogeneity value of magnetic field Bo decreases from $1.45 \times 10^{-6}$ (Fig. 2A) to about $6.5 \times 10^{-7}$.

In probe head 30 of Figs. 3A-C, the residual susceptibility broadening is mainly caused by connection conductor 16 between first conductor 11 and second conductor 12.

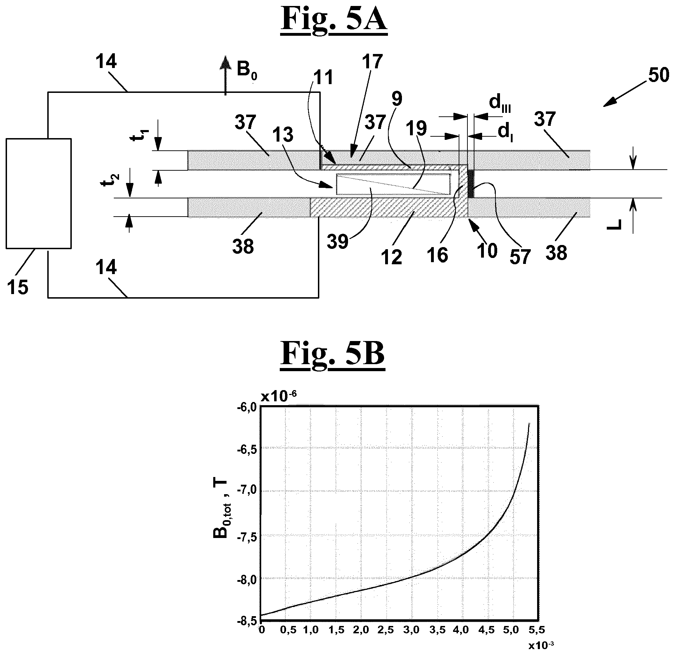

Fig. 5A shows a probe head structure 50 according to another exemplary embodiment of the present invention, obtained as a modification of probe head structure 30, in which a further element 57 having a predetermined magnetic susceptibility has been added proximate to connection conductor 16, in order to decrease the magnetic susceptibility contribution thereof. Element 57 having a predetermined magnetic susceptibility serves as a magnetic balancing extension. It is made of a material III that has a susceptibility $\chi_{m,mIII}$ of opposite sign with respect to the susceptibility $\chi_{m,mI}$ of material I, and has a shape and/or a size and/or a position configured to compensate the contribution of connection conductor 16.

Preferably, the relationship between the side thickness of connection conductor 16 and the side thickness $d_{III}$ 8 of further element 57 having a predetermined magnetic susceptibility is:

$$d_I |\chi_{m,mI}| = d_{III} |\chi_{m,mIII}|,$$

where expressions as $|\chi_m|$ indicate the absolute value of magnetic susceptibility of material I and of material III.

Fig. 5B shows the distribution of static field Bo in measurement zone 13 of probe head 50, along line 19 connecting the points of maximum variation of static magnetic field Bo. These data relate to a structure 30 as described when referring to Fig. 4, to which a further aluminium element 57 having a predetermined magnetic susceptibility has been added, arranged in contact with connection conductor 16. Element 57 had a side thickness $d_{III}$ = 0.126 mm and a height equal to the distance between second conductor 12 and first conductor 11 of RF-coil 10, in this case 2.4 mm. The magnetic susceptibility of aluminium, as material III, is $\chi_{m,mIII} = \chi_{m,Al} = 2.3 \times 10^{-5}$.

With probe head 50, the maximum inhomogeneity value of magnetic field $B_0$ decreases to about $2.2 \times 10^{-7}$.

Elements 37,38,57 having predetermined magnetic susceptibilities must not be flat plates or strips, but can have any shape, any size, any position and any magnetic susceptibility value, provided they are combined, in such a way to provide a favourable distribution of static magnetic field Bo, i.e. to reduce its non-uniformity.

Besides the elements of the structure, also sample 39 and the sample holder, not shown, can have an own magnetic susceptibility suitable for modifying static magnetic field Bo.

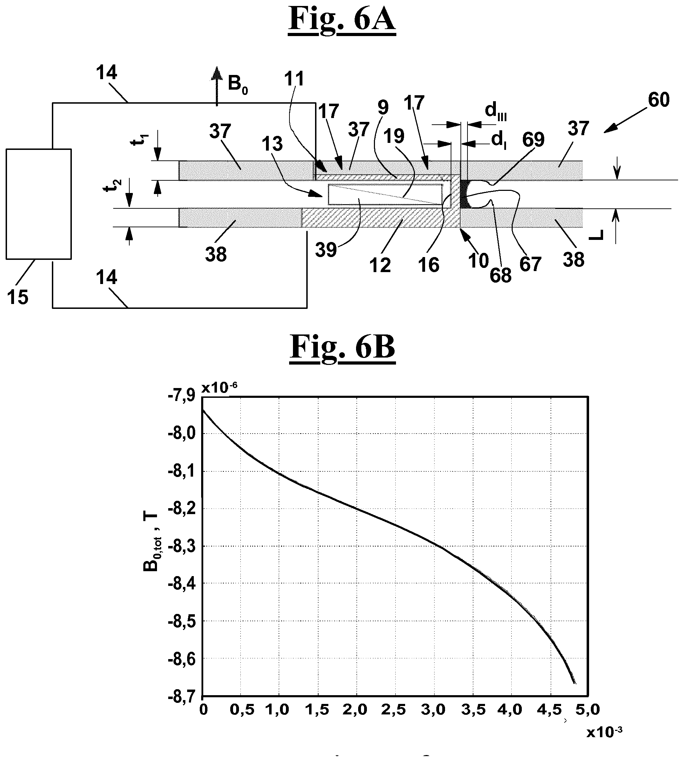

Fig. 6A shows a probe head structure 60 similar to probe head structure 50, in which an element 67 having a predetermined magnetic susceptibility has been added to serve as magnetic balancing extension. Element 67 can be positioned the same way as element 57 of Fig. 5A, and can have an at least in part curvilinear cross section or, more in general a non-flat shape. In this case, element 67 having a predetermined magnetic susceptibility has a face oriented towards connection conductor 16, in particular it can have a flat face arranged in contact with the connection conductor 16, and a concave opposite face. The extra-thickness of the upper and lower zones 68,69 of element 67 serves to reduce the residual variations of field Bo at upper and lower portions of connection conductor 16.

Fig. 6B shows the distribution of static field $B_0$ in measurement zone 13 of probe head 60 of Fig. 6A, along line 19 connecting the points of maximum variation of static magnetic field $B_0$.

The data relate to a structure 30 as described when referring to Fig. 4, in which the concave surface of element 67 having a predetermined magnetic susceptibility is a portion of a cylinder surface and has a curvature radius of 5 mm. The minimum side thickness is equal to the thickness of element 57 having a predetermined magnetic susceptibility of probe head structure 50, and to the thickness of any other parts of RF-coil 10.

In this exemplary embodiment, the maximum inhomogeneity value of magnetic field Bo is reduced to about $7.4 \times 10^{-8}$.

Better results can be obtained by increasing the number of elements having predetermined magnetic susceptibility and improving their shapes, and/or dimensions, and/or positions, or by reducing the size of measurement zone 13.

The thicknesses $t_1$ and $t_2$ of side elements 37,38, respectively, adjacent to first conductor 11 and to second conductor 12 of Figs. 3A,5A,6A, can be different from one another, provided side elements 37,38 are configured and arranged to provide an equivalent or small magnetic contribution.

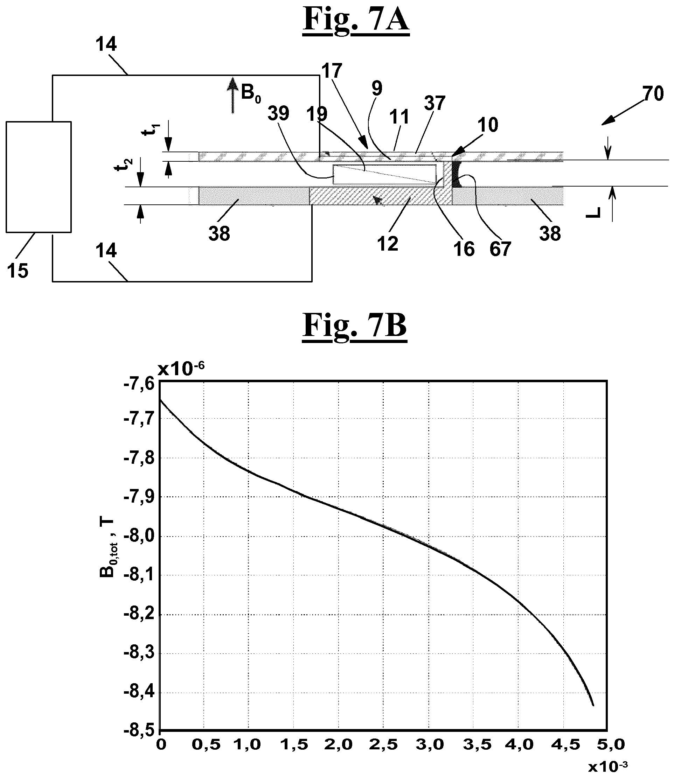

Fig. 7A shows a probe head structure 70 similar to probe head structure 30, in particular to probe head structure 60, in which the width d is far larger than substantially uniform thicknesses $t_1$ and $t_2$ of side elements 37,38 having predetermined magnetic susceptibilities and far larger than the relative distance between elements 37,38. Thicknesses $t_1$ and $t_2$ are selected so as to satisfy the relationship:

$$t_1 \chi_{m,mII} = t_2 \chi_{m,mII'}, \qquad [1]$$

where $\chi_{m,mII}$ and $\chi_{m,mII'}$ are the substantially uniform magnetic susceptibilities of elements 37,38 adjacent to first conductor 11 and to second conductor 12 of RF-coil 10, respectively. This relationship expresses a condition in which elements 37,38 have equivalent magnetic susceptibilities. In particular, second conductor 12 is made of material I and first conductor 11 is made of a material Ib different from material I. The material in which connection conductor 16 is formed can be the material I or material Ib, or a material different from both of them. Elements 37,38 are advantageously made of materials II and IIb having magnetic susceptibility $\chi_{m,mII}$ and $\chi_{m,mIIb}$ similar to magnetic susceptibility and $\chi_{m,mI}$ and $\chi_{m,mIb}$ of materials I, Ib, respectively, i.e. such that the differences $\chi_{m,mII} - \chi_{m,mI}$ and $\chi_{m,mIIb} - \chi_{m,mIb}$ are lower than a predetermined value.

In order to meet the condition of equivalent magnetic contributions, thicknesses $t_1$ and $t_2$ can be selected so as to satisfy the relationship:

$$t_1\, \chi_{m,mII} = t_2\, \chi_{m,mIIb}. \qquad [2]$$

Fig. 7B shows the distribution of static field $B_0$ in measurement zone 13 of probe head 70 of Fig. 7A, along line 19 connecting the points of maximum variation of static magnetic field $B_0$.

The data relate to a structure 70 in which second conductor 12 and connection conductor 16 are still made of copper, whereas first conductor 11 and the element having a predetermined magnetic susceptibility 38 adjacent to second conductor 12 are made of gold ($\chi_{m,Au} = -3.44 \times 10^{-5}$). Thinner element 37 having a predetermined magnetic susceptibility has a thickness $t_1 = 0.56$ mm and width d = 36 mm, including first conductor 11 of RF-coil 10.

In this exemplary embodiment, the maximum inhomogeneity value of magnetic field Bo is about $8 \times 10^{-8}$.

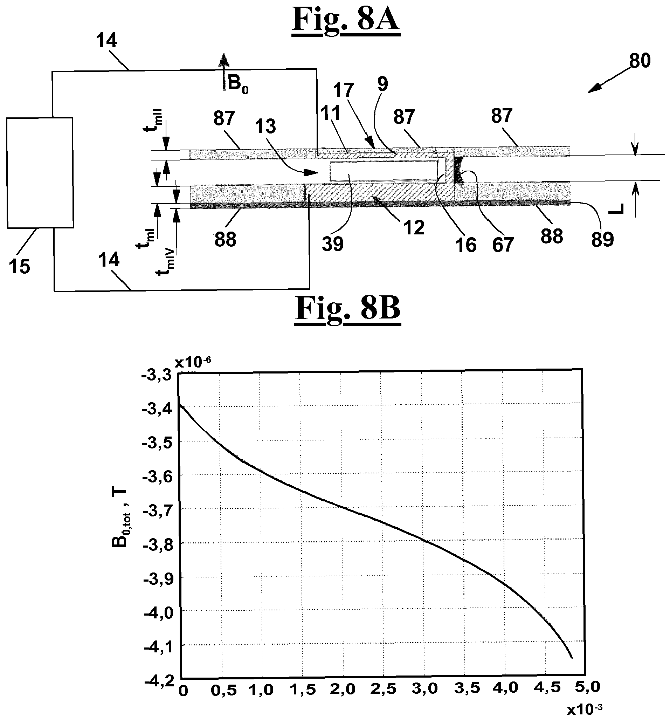

Figs. 8A-14D refer to further exemplary embodiments, in which a plurality of m elements "i" having predetermined magnetic susceptibilities $\chi_{m,1,i}$ and $\chi_{m,2,i}$, and having the shape of layers of thicknesses $t_{1,i}$ and $t_{2,i}$ are arranged at the first and second conductors 11,12, respectively, of RF-coil 10. In particular, the thicknesses of the layers are selected so as to satisfy the relationship:

$$t_{1,1}\chi_{m,1,1} + t_{1,2}\chi_{m,1,2} + ... = t_{2,1}\chi_{m,2,1} + t_{2,2}\chi_{m,2,2} + ... \qquad [3]$$

in which the susceptibilities are considered with their own algebraic sign. This relationship approximately expresses the condition according to which first conductor side portion and second conductor side portion provide equivalent magnetic contributions.

In particular, Fig. 8A shows a probe head structure 80 in which RF-coil 10 is made of a single material I. First conductor 11 and second conductor 12 extend within elements 87,88 having predetermined magnetic susceptibilities made of a material II of susceptibility similar to the susceptibility of material I. Along the outer face of second conductor 12 and of the elements 88 having predetermined magnetic susceptibilities adjacent to it a further element having a predetermined magnetic susceptibility in the form of a layer 89 made of a material IV of magnetic susceptibility $\chi_{mIV}$, opposite to susceptibility $\chi_{mI}$ of material I.

Layer 89 serves to partially compensate for the effects on susceptibility provided by the regions of material I and of material II of the portion of probe head 80 including second conductor 12. In this case, the relationship approximately expressing the condition according to which upper portions 11,87 and lower portions 12,88,89 of probe head 80 provide equivalent magnetic contributions is:

$$t_1\, \chi_{m,mII} = t_{2,1}\, \chi_{m,mI} + t_{2,2}\, \chi_{m,mIV} = t_{2,1}\, \chi_{m,mI} - t_{2,2}\, |\chi_{m,mIV}|$$

The remainder parts of probe head structure 80 is similar to the corresponding parts of probe head structure 60 of Fig. 6A.

Fig. 8B shows the distribution of static field $B_0$ in measurement zone 13 of probe head 80 of Fig. 8A, along line 19 connecting the points of maximum variation of static magnetic field $B_0$.

The data relate to structure 80 in which material I is copper, material II is PTFE, and material III and IV are Aluminium. The thickness of first conductor 11 of the RF-coil is $t_{mII} = 1$ mm, while the thickness of compensation layer 89 is $t_{mIv} = 0.420$ mm. The other dimensions are the same as the corresponding dimensions indicated when describing Fig. 6B.

In this further exemplary embodiment, the maximum inhomogeneity value of magnetic field Bo is about $7.5 \times 10^{-8}$.

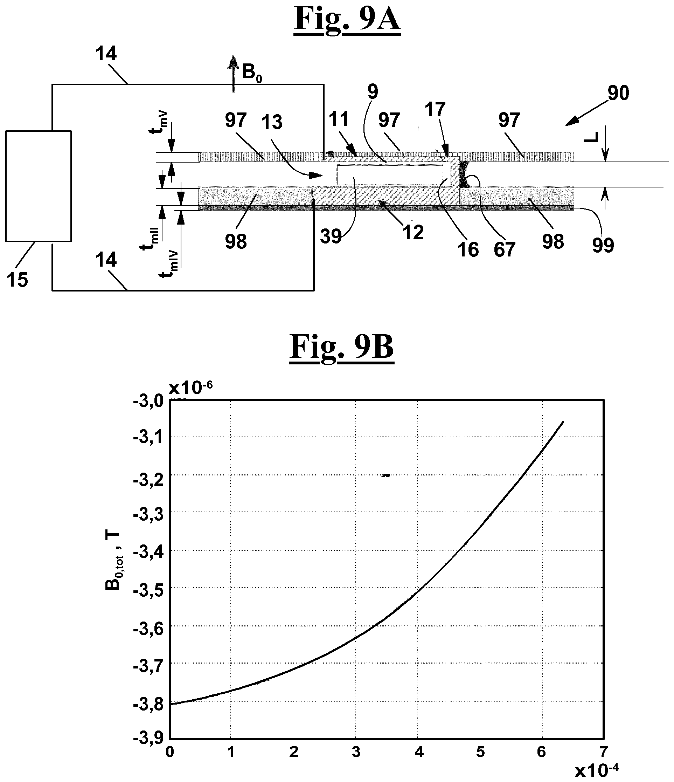

Fig. 9A shows a probe head structure 90 comprising a plate 97 as an element having a predetermined magnetic susceptibility. Plate 97 is made of a material V having magnetic susceptibility $\chi_{mV}$ different from the other materials of probe head 90. Preferably, $\chi_{mV}$ is similar to the susceptibility of second conductor 12 of RF-coil 10. Probe head structure 90 also comprises layers 97,98 corresponding to layers 87,88 of probe head structure 80 (Fig. 8A).

The portion of probe head 90 adjacent to first conductor 11 can include linear conductor elements 9. The remainder parts of probe head 90 can be similar to the corresponding parts of probe head structure 80 of Fig. 8A.

If $\chi_{mV}$ has opposite sign with respect to $\chi_{mI}$, the relationship approximately describing the condition according to which of first conductor 11, plate 97, second conductor 12 and elements 98,99 provide equivalent magnetic contributions is:

$$t_1 \, \chi_{m,mV} = t_{2,1} \, \chi_{m,mI} + t_{2,2} \, \chi_{m,mIV} = t_{2,1} \, \chi_{m,mI} - t_{2,2} \, |\chi_{m,mIV}|.$$

Fig. 9B shows the distribution of static field $B_0$ in measurement zone 13 of probe head 90 of Fig. 9A, along line 19 connecting the points of maximum variation of static magnetic field $B_0$.

The data relate to a structure 90 in which materials I-IV are those indicated when describing Fig. 8B, while material V is quartz (material V, $\chi_{m,Qtz} = -1.34 \times 10^{-5}$). The thickness $t_{mV}$ of compensation layer 99 is $t_{mV} = 0.78$ mm. The other dimensions are the same as the corresponding dimensions indicated when describing Fig. 8A.

In this exemplary embodiment, the maximum inhomogeneity value of magnetic field $B_0$ is about $7.4 \times 10^{-8}$.

In the exemplary embodiments of Figs. 8A,9A, there is a wide freedom of choice of both the thicknesses and the magnetic susceptibilities of elements 87,88,89,97,98,99 having predetermined magnetic susceptibilities.

Other embodiments can be obtained by combining the exemplary embodiments described above. More in detail, one or more elements having predetermined magnetic susceptibilities of appropriate shapes, dimensions, magnetic susceptibilities and positions can be combined with RF-coil 10 of Fig. 1A-1C, and in any other parts of the probe head, in such a way to minimize the susceptibility broadening, i.e. the broadening of the shape of the magnetic resonance lines, in particular, in measurement zone 13.

Preferably, the minimum thickness $t_{mII}$ of elements 87 having predetermined magnetic susceptibilities that are combined with first conductor 11 of RF-coil 10 of probe head 80 (Fig. 8A) is equal to the minimum thickness of linear conductor elements 9, when the latter are present. This makes it possible to stabilize the suddenly changing magnetic susceptibility contributions in measurement zone 13, due to linear conductor elements 9 that can form first conductor 11 of RF-coil 10.

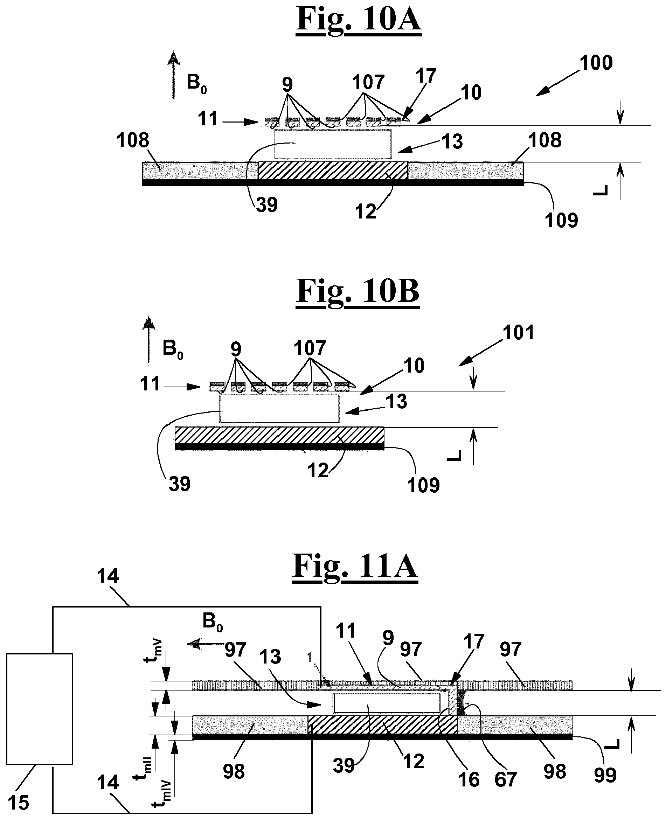

Fig. 10A shows a probe head structure 100 according to a further exemplary embodiment in which first conductor 11 comprises linear conductor elements 9 at a distance from one another. In particular, probe head structure 100 comprises an element 107 having a predetermined magnetic susceptibility as an extension of the first conductor. Similarly to probe head structure 50 of Fig. 5, the material of element 107 has a magnetic susceptibility opposite sign to the magnetic susceptibility of the material of linear conductor elements 9, in order to compensate the magnetic susceptibility contribution of linear conductor elements 9.

In particular, the magnetic susceptibility contribution of second conductor 12 in measurement zone 13 is a similar way by an element 109 having a predetermined magnetic susceptibility made of the same material or of a different compensation material. The magnetic susceptibility contribution of the edges of second conductor 12 of RF-coil 10 in measurement zone 13 is maintained at a negligible value by adding side elements 108 having predetermined magnetic susceptibilities and made of a material II that has a magnetic susceptibility similar to the magnetic susceptibility of material I of RF-coil 10, similarly to probe head structure 30 of Fig. 3.

Fig. 10B shows a probe head structure 101 in which the edges of second conductor 12 of RF-coil 10 do not significantly contribute to the homogeneity of the static magnetic field in measurement zone 13, since they are located far enough from it.

In the exemplary embodiments of Figs. 10A-B, non-planar shapes can be used for various parts of RF-coil 10, in order to improve the homogeneity of the static field, similarly to probe head structure 60 of Fig. 6A.

Even if the direction of static field $B_0$ in the examples described so far is always orthogonal to main portions 11,12 of the probe heads, in particular to first conductor 11 and to second conductor 12, static field Bo can have any direction. For instance, Fig. 11A shows a probe head structure 110 that is substantially equal to probe head structure 90 of Fig. 9, but the direction of static magnetic field $B_0$ lies in a plane parallel to first conductor 11 and to second conductor 12.

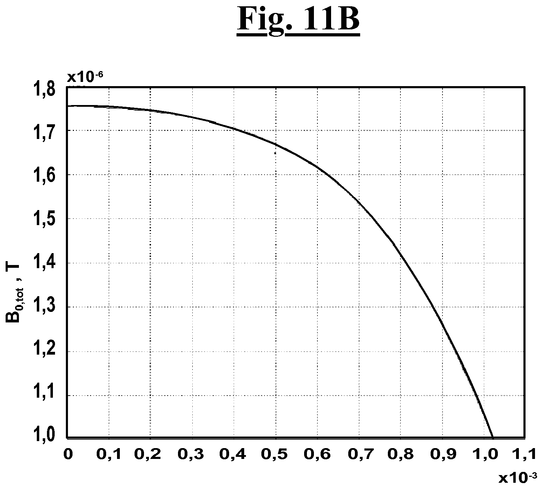

Fig. 11B shows the distribution of static field $B_0$ in measurement zone 13 of probe head 110 of Fig. 11A, along line 19 connecting the points of maximum variation of static magnetic field $B_0$. The dimensions and the and magnetic susceptibilities are the same as indicated in the description of Fig. 9B.

In this case, the maximum inhomogeneity value of magnetic field $B_0$ is about $7.5 \times 10^{-8}$.

Probe head structures 50,60 of Figs. 5 and 6 indicate possible approaches to reduce the distortion of static field $B_0$ due to connection conductor 16 arranged between second conductor 12 and first conductor 11 of RF-coil 10. In these structures, the finite length *l* of connection conductor 16 has been neglected. However, this length can affect the distribution of the static field if the edges of connection conductor 16 are too close to measurement zone 13.

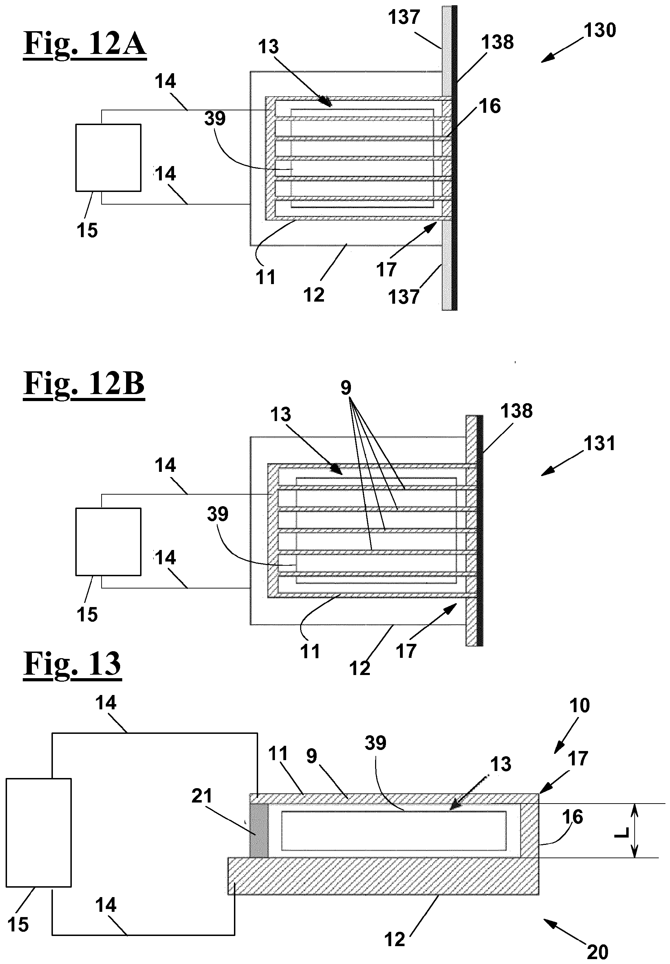

This problem can be taken into account as in the probe head structure 130 of Fig. 12A, in which the edges of connection conductor 16 are spaced from measurement zone 13 by a spacer portion 137. Spacer portion II is made of a material II that has a magnetic susceptibility similar to the material of connection conductor 16. Moreover, in probe head structure 130 an element 138 having a predetermined magnetic susceptibility is provided in the form of a layer that is made of a material III and is arranged along connection conductor 16. Element 138, is arranged to compensate the susceptibility of the material of the spacer portion 137, similarly to the solution proposed in Fig. 5. It will be understood that that the magnetic susceptibility contributions of the other components of RF-coil 10, and more in general of probe head 130, can be balanced or compensated according to any of the previously described exemplary embodiments.

Fig. 12B shows a probe head structure 131 in which the edges of connection conductor 16 are located at a suitable distance from measurement zone 13 by appropriately choosing their length. Structure 131 comprises an element 138 having a predetermined magnetic susceptibility that is made of a material III, selected in such a way to compensate the susceptibility of material I.

According to probe head structure 60 of Fig. 6A, the different portions of the probe head of the invention must not necessarily have a planar shape or be in the form of stripes. On the contrary, they can have any shape and/or size and/or position and/or magnetic susceptibility, provided they are combined and arranged in such a way to provide a favourably uniform distribution of static field $B_0$. Similarly, the number of elements having predetermined magnetic susceptibilities and, more in general, the number of portions made of a material different from the material of RF-coil 10 can be any number. This applies, in particular, for additional elements arranged about connection conductor 16.

Even if the probe heads described so far comprise an RF-coil 10 based on the RF-coil of one exemplary embodiment of WO 2013/000964 (Fig. 1), the elements having predetermined magnetic susceptibilities can be added to anyone of the RF-coils described that document, thus obtaining corresponding pluralities of exemplary embodiments of the present invention.

In particular, Fig. 13 diagrammatically shows an RF-coil 20 comprising a mechanical stiffening element 21 made of a material VI that is preferably an insulating material and/or a low RF-loss material, arranged between first conductor 11 and second conductor 12 at ends opposite to the ends at which connection conductor 16 is arranged. Stiffening element 21 serves to improve stiffness and mechanical strength of probe head structure 20, maintaining the linear conductor elements, not shown, of first conductor 11 at their position.

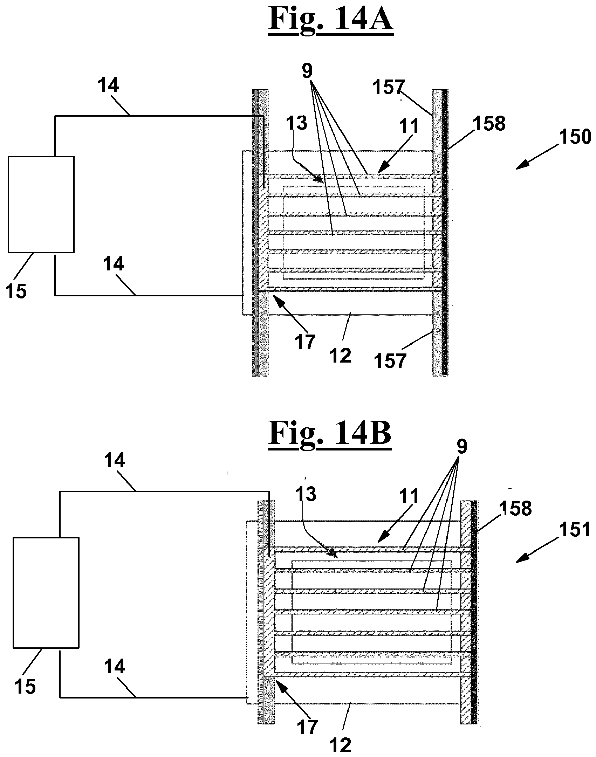

Figs. 14A and 14B show probe head structures 150 and 151 according to the invention, in which an RF-coil 20 is provided of the type shown in Fig. 13, and which also comprise elements 157,158 having predetermined magnetic susceptibilities. Elements 158,159 serves to compensate the effects of stiffening element 21 on susceptibility and to maintain the edges thereof properly spaced apart from measurement zone 13. In particular, element 157 having a predetermined magnetic susceptibility of Fig. 14A is made of a different material, while element 158 having a predetermined magnetic susceptibility of Fig. 14B is made of the same material.

Similar approaches can be used for other possible components of the probe head that can possibly be inserted in the two free sides of measurement zone 13 of Figs. 14A-B. Moreover, the exemplary embodiments of Figs. 14A-B can be combined with anyone of the above-described exemplary embodiments, in order to obtain the required mitigation of the magnetic susceptibility effects.

In the configurations in which the approximation $d \gg t$ is not satisfied for some of the elements having predetermined magnetic susceptibilities, or in which the relative distances and the positions between the probe head components cannot be neglected, the shape and/or the dimensions and/or the positions and/or the magnetic susceptibilities of the material of the elements having predetermined magnetic susceptibilities can be calibrated, in order to obtain obtained an appropriately uniform distribution of static magnetic field Bo in measurement zone 13. In particular, one part of the elements having predetermined magnetic susceptibilities can need curve profiles, as shown in the exemplary embodiments of Figs. 6A, 7A, 8A, 9A.

All the above embodiments can be generalized to an arbitrary number of elements having arbitrary magnetic susceptibilities, positions, dimensions, and shapes.

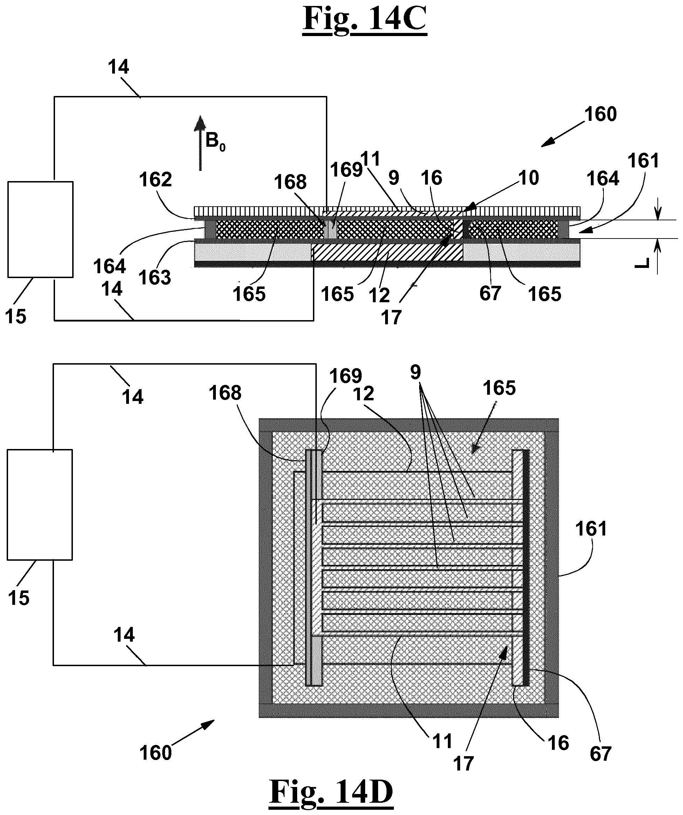

Figures 14C-F show probe head structures in which a sample holder is provided for locating a sample. These structures comprise elements and materials having predetermined magnetic susceptibilities in order to mitigate the *Susceptibility Broadening* and the effects of static magnetic field distortion in measurement zone 13 due to the sample and to the sample holder. The sample holder can be provided by one of the elements having predetermined magnetic susceptibilities according to anyone of the exemplary embodiments described above or, as an alternative, it can be a further component of the probe structure.

In particular, Figs. 14C and 14D show a probe head structure 160 based on the structures of Figs. 9A and 14A. Probe head structure 160 includes a sample holder 161 comprising layers 162,163 and made of a material having a given magnetic susceptibility. In this exemplary embodiment, layer 162 lies on first conductor 11 and on the elements having predetermined magnetic susceptibilities adjacent to first conductor 11, while layer 163 lies on second conductor 12 and on the elements having predetermined magnetic susceptibilities adjacent to second conductor 12. In particular, layers 162 and 163 are arranged proximate to connection conductor 16 and to elements 67,168,169. The thickness of layers 162,163 is selected in such a way to obtain a balanced contribution to static magnetic field Bo in measurement zone 13 of RF-coil 10, where it is concentrated most of the energy magnetic of radiofrequency, as already discussed in connection to previously described exemplary embodiments.

Sample holder 161 can be sealed by means of sealing elements 164 arranged at a given distance from measurement zone 13 of RF-coil 10. This way, sample holder 161 cannot cause a significant modification of static magnetic field Bo in measurement zone 13.

In the preferred exemplary embodiment of Figs. 14C and 14D, sample holder 161 is completely filled by a sample 165, which extends even outside of measurement zone 13. This distribution of sample 165 does not significantly affect the symmetry of probe head structure 160 with respect to magnetic susceptibility contributions. Moreover, the edges of sample 165 cannot provide a relevant contribution to static field distortion in measurement zone 13, since the latter is located far enough from the edges of sample 165 for structural reasons. Therefore, this exemplary embodiment can be treated as any of the exemplary embodiments described above, with the only difference that in the approaches based on the compensation of the susceptibility contribution of a component of the probe head surrounded by the sample, this compensation must by calibrated on the magnetic susceptibility of the sample and not on that of the vacuum.

As the above-described exemplary embodiments illustrates, in particular those of Figs. 5A-10B and 11A-B, a very large part of the active region of the RF coil is characterized by a highly homogeneous field $B_0$. Hence, the large majority of sample 39 gives a magnetic resonance signal with limited susceptibility broadening, in particular in the cases of weak nuclear spin diffusion.

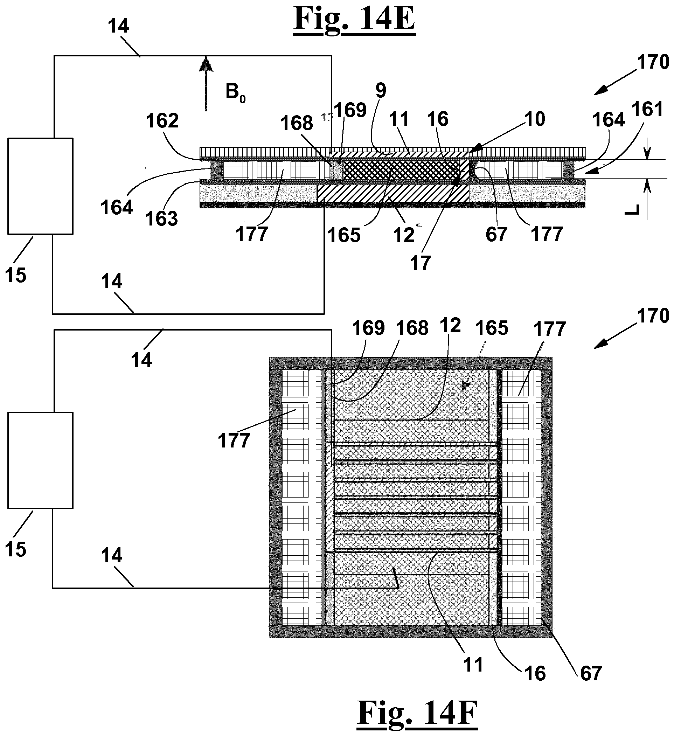

Figs. 14E and 14F show a probe head structure 170, in which sample holder 161 is partially filled with a sample 165. The remainder part of sample holder 161 is preferably filled with a material 177 of about the same magnetic susceptibility as the sample. In the case of relatively low concentration solutions, material 177 can be a solvent. The separation between sample and 165 and material 177 can be possibly obtained by means of elements 16,168,169, as shown in Figs. 14E and 14F. The shape, volume, filling factor, and relative position of sample 165 and of extra material 177 can be arbitrary.

In the exemplary embodiments of Figs. 14C-F, the direction of static field $B_0$ can be arbitrary, as well as the filling level of sample 165 and material 177, which can be partial, or can extend also below second conductor 12 and above first conductor 11. In the case of liquid sample 165, the loading of sample holder 161 can be obtained by elements 164, whose shape does not introduce a relevant static field distortion of field Bo in measurement zone 13 of RF-coil 10.

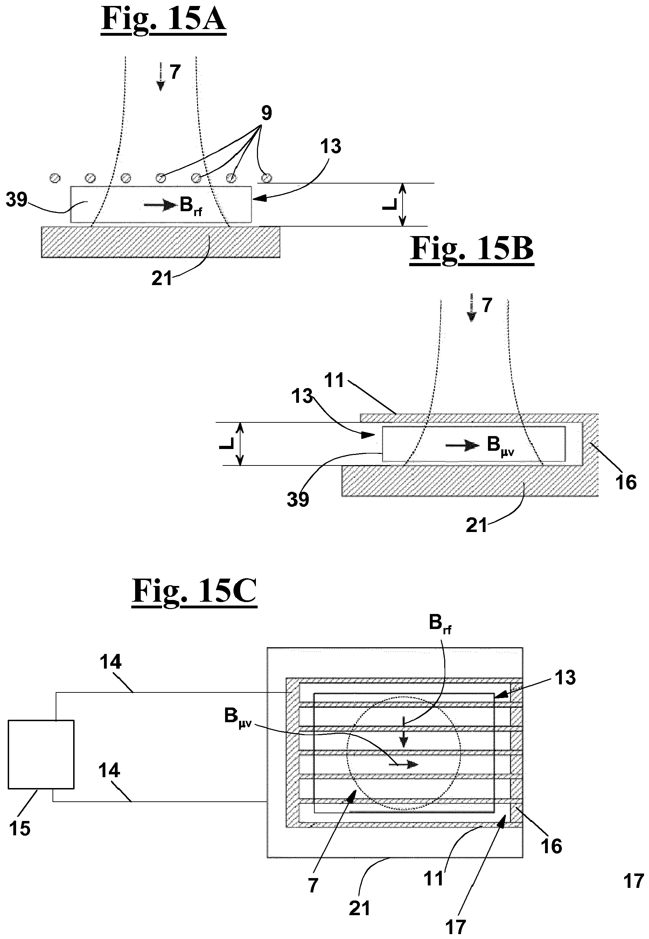

DNP-NMR probe heads enabling improved spectral resolution will be now described. In these probe heads, the excitation of the EPR transitions can be obtained by microwave irradiation of sample 39, as diagrammatically shown in Fig. 15, through a microwave radiation 7 preferably polarized orthogonal to first conductor 11. For the sake of simplicity, in Figs. 15A, 15B, 15C the lateral extension are omitted. The same applies to Fig. 13.

Probe heads that are suitable for DNP-NMR techniques can be obtained by a modification of any of previously described probe heads, in which first conductor 11 is at least partially permeable to microwaves, so that microwave radiation 7 can achieve measurement zone 13, while the second conductor 12 is configured to reflect microwave radiation 7.

In particular, first conductor 11 can comprise a conductive grid consisting of linear conductor elements 9, for example as in Figs. 1A, 10A or 10B, 12A-B or 13A-B, i.e. in one of the forms provided in WO 2013/000964. In particular, second conductor 12 can comprise a reflecting plate, made according to one of the forms provided in WO 2013/000964.

Moreover, previously mentioned side elements 37,38,87,97,107, 157,187 having predetermined magnetic susceptibilities, which are arranged at first conductor 11, i.e. those side elements that must be crossed by microwaves 7, are substantially transparent to microwaves 7. To this purpose, the material of such elements must have low microwave absorption in the working conditions of the probe head. The number and/or the physical characteristics and/or the shape and/or the size and/or the position of these elements and materials having a predetermined magnetic susceptibility can be otherwise arbitrary.

For example, if the wavelength of microwaves 7 is of the order of millimetres, materials with low absorption at room temperature are given by PTFE, single-crystal quartz, sapphire, high-resistivity silicon, and so on, whereas at very low temperatures many other materials have weak microwave absorption.

Moreover, side elements 37,38,87,97,107,157,187 having predetermined magnetic susceptibilities arranged at first conductor 11 are selected so that they cannot cause significant reflections of microwaves 7.

This way, new DNP-NMR probe heads are obtained that provide an efficient microwave excitation of sample 39 with, and therefore a high sensitivity, as well known from WO 2013/000964, and can ensure at the same time a high homogeneity of static field Bo in the measurement region 13 of RF-coil 10, and therefore a high spectral resolution.

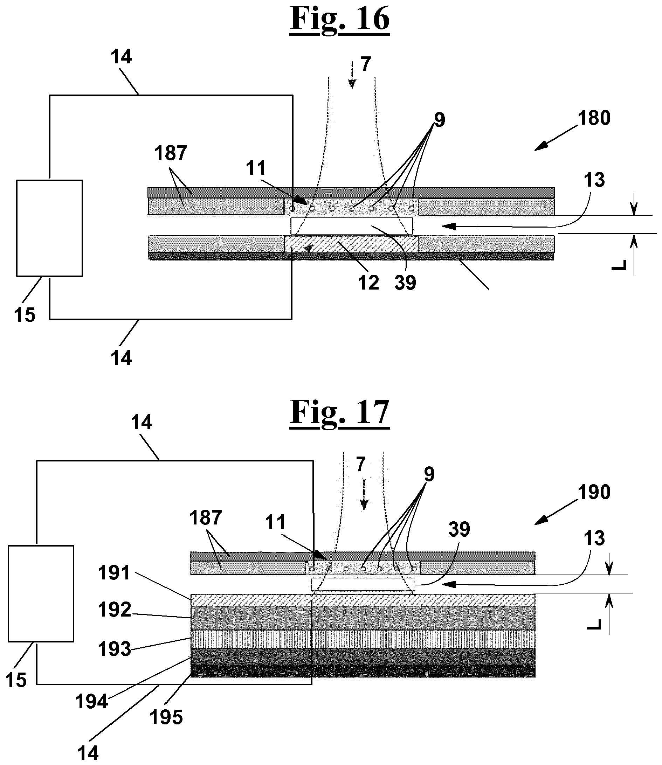

A good penetration of microwave radiation 7 up to measurement zone 13 can be obtained in a probe sample 180 according to a further exemplary embodiment of the invention, as shown in Fig. 16, in which the thickness $t_1$ of low microwave loss element 187 forming the portion of probe head 180 exposed towards microwaves 7 is much smaller than the wavelength $\lambda_{mw}$ of microwaves 7, i.e., $t_1 << \lambda_{mw}$. This way, incoming microwaves 7 are only weakly reflected.

In a further exemplary embodiment, the thicknesses of the different regions that form the portion of the probe head exposed towards microwaves 7, which is assumed distributed in planar layers, are such that the following sum, expressing to overall optical thickness $\tau_{1,opt}$ of this portion:

$$\tau_{1,opt} = \tau_{w/s} + t_{1,1}n_{1,1} + t_{1,2}n_{1,2} + \ldots = \tau_{w/s} + \sum_{j=1}^{N} t_{1,j} n_{1,j} \, ,$$

wherein

- $t_{1,j}$ is the geometric thickness of the j-th layer of the portion of the probe head exposed towards the microwaves;
- $n_{1,j}$ is the microwave refraction index of this j-th layer;
- the sum extends over all the N layers of the portion of the probe head exposed towards the microwaves;
- the term $\tau_{w/s}$ represents the contribution of the propagation through linear conductor elements 9 that form grid 11,

is such that $\tau_{1,opt}$ corresponds to a multiple m of $\lambda_{mw}/2$ or such that $\tau_{1,opt}$ is close to this condition, i.e. $\tau_{1,opt} \sim m^*\lambda_{mw}/2$. This condition ensures a high transmission of microwaves 7 up to sample 39 in measurement zone 13.

In a more general case, in which the elements of the portion of the probe head exposed towards microwaves 7 are not arranged in layers, the condition of maximum transmission of microwaves 7, and of corresponding low reflection of microwaves 7, can be expressed in terms of the total phase variation $\phi_1$ experienced by microwaves 7 in a single pass through the portion of the probe head exposed to microwaves 7, which must be equal or close to an integer multiple of $\pi$, i.e., $\phi_1 \sim m^*\pi$, with m integer number.

In a further exemplary embodiment, the known techniques of the antireflection coating or films can be applied to the cases in which the portion of the probe head exposed to microwaves 7 is composed by a multi-layer structure, in order to minimize the reflection of microwaves 7 and, therefore, in order to obtain a maximum irradiation of sample 39.

These last exemplary embodiments can advantageously be combined with each of the previously described ones.

DNP-NMR probe heads are now described that make it possible to perform an intermediate heating of the sample, after the nuclear spin polarization step and before the true measurement step. In particular, reference is made to DNP-NMR techniques in which the melting of the sample is required.

The DNP-NMR probe heads according to the invention, allowing medium-to-high resolution NMR measurements, can be applied to new versions of the so-called temperature-jump DNP technique, or dissolution DNP technique, in which the non-thermal nuclear polarization induced by the microwave irradiation is obtained at very low temperatures, whereas the NMR measurements of interest are made at room temperature or at a predetermined temperature of interest, at which the sample is expected to be in the liquid state. These techniques can be referred to as melting DNP techniques.

The invention makes it possible to perform medium-to-high resolution *in situ* NMR measurements, using the same probe head and the same setup for both polarizing the sample at low temperature, and monitoring the progress of the dynamic nuclear polarization step, and finally determining the NMR signal of the sample with the requested resolution after it has been heated.

Three possible non-limiting applications of exemplary embodiments of the invention to melting-DNP techniques will now be considered more in detail.

In a first version, the melting-DNP technique is performed by means of probe head 180 of Fig. 16. Sample 39 can be heated from the polarization temperature to the NMR or MRI measurement temperature by a hot solvent, as in the case of a standard DNP dissolution technique, or by an electromagnetic irradiation at infrared frequencies, as in the case of a temperature jump technique.

The heating irradiation can be carried out at different electromagnetic frequencies, such as microwave frequencies.

Preferably, the sample is that is are arranged to have a high ratio surface/volume, which can be obtained, for instance, by the probe head described in WO 2013/000964 or by probe head 180 of Fig. 16, which allow allows other approaches to the sample heating.

In a preferred embodiment, sample 39 can be heated by an electric current pulse or by a sequence of electric current pulses $I_{ht}$.

For instance, Fig. 17 shows a probe head structure 190 in which the portion of RF-coil opposite to the portion exposed to microwave radiation 7 comprises a plurality of layers. A first layer 191, adjacent to measurement zone 13, can be made of a conductive material, in order to allow the propagation of RF currents $I_{rf}$ with low electric resistance. Preferably, first layer 191 has a thickness low, so that its heat capacity is low enough to allow a fast thermal propagation. For instance, first layer 191 can be made of copper and have a thickness equal to a small multiple of the RF skin depths.

Advantageously, a second layer 192, adjacent to first layer 191, is made of an electrically insulating material but is preferably characterized by a good thermal propagation, for example it can be a thin layer and/or a layer made of a high- thermal conductivity material. For instance, second layer 192 can be a quartz or sapphire layer.

A third layer 193 is preferably made of a low-electrical conductivity material, and/or it is a layer thin enough to exhibit an appropriate electric resistance, in order to enables heating the RF coil and sample 39 by either continuous or alternating electric current pulses.

The frequency of the electric current pulses heating the system and their sequence should be chosen to have a minimal net effect on the spin polarization. The electric circuits for the heating current and for the RF current can be fully separated, or can have common components.

Probe head structure 190 can also comprise further layers 193,194 in order to ensure a possible thermal insulation towards the support of the RF-coil, and/or to ensure the susceptibility compensation, and/or to ensure the necessary mechanical stability.

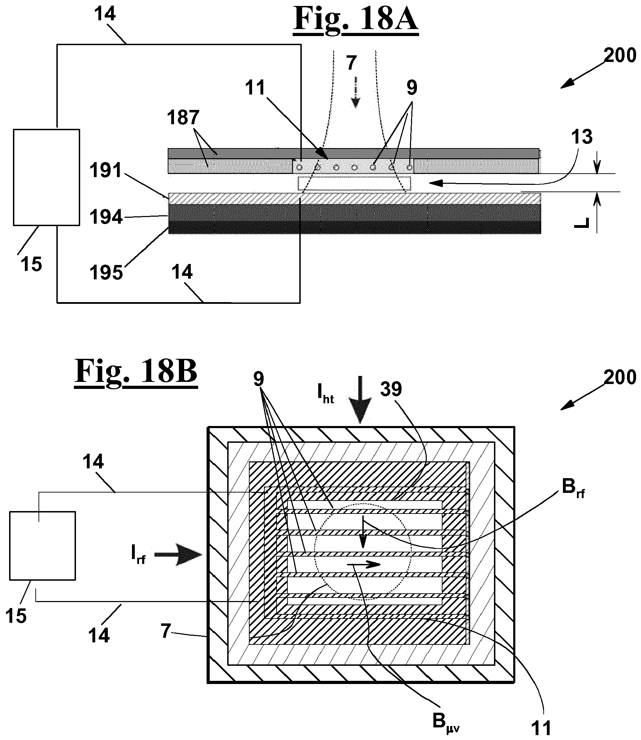

Fig. 18A shows a probe head structure 200 in which first layer 191, on the RF-coil side opposite to the side exposed to microwave radiation 7, is used both as a part of the electric RF coil, and as a part of the electric circuit carrying heating current $I_{ht}$. Advantageously, the thickness of first layer 191 is high with respect to the RF skin depth, but small with respect to the skin depth of the heating current $I_{ht}$. This way, both high RF performances and a localized heating by heating current $I_{ht}$ can be obtained. A similar result can be obtained by keeping the thermal capacity of the probe head low with respect to the thermal capacity of the external electric circuit carrying the $I_{ht}$ current. Normally, the thickness of the material of first layer 191 can be arbitrary.

Also in this embodiment, further layers 194,195 can be provided adjacent to first layer 191 in order to add a proper thermal capacity, or for susceptibility compensation purposes, or for the necessary mechanical stability of the probe head.

In this embodiment, first layer 191 can be advantageously configured in such a way that the heating current $I_{ht}$ and the RF current $I_{RF}$ are orthogonal to each other, as shown in Fig. 18B. This way, can be obtained different capacity to heating for two currents $I_{RF}$ and $I_{ht}$. To this purpose, first layer 191 can have an anisotropic electrical conductivity. This can be achieved by combining suitably different material or by using a suitable local structure of first layer 191 that can comprise, for instance, a sequence of slits directed along the RF current $I_{rf}$.

In general, the local relative direction of the two currents $I_{rf}$ and $I_{ht}$ can be arbitrary.

In both cases, at the end of the melting and magnetic resonance characterization processes, melted sample 39 can be quickly expelled from the probe head 190 or 200, and can be employed, for instance, for MRI purposes.

In conclusion, the problem of providing apparatuses enabling medium-to-high resolution DNP-NMR techniques with high polarization efficiency, which are compatible with large temperature variations of the sample, in particular, in a very short time, during which the achieved spin polarization is not significantly attenuated. In order to reach this object, the problem of the susceptibility broadening in NMR spectra caused by the susceptibility contribution of the basic components of the probe head, i.e. RF-coil 10, sample holder 161, and sample 38 itself.

The foregoing description of exemplary embodiments of the invention will so fully reveal the invention according to the conceptual point of view, so that others, by applying current knowledge, will be able to modify and/or adapt in various applications the specific exemplary embodiments without further research and without parting from the invention, and, accordingly, it is meant that such adaptations and modifications will have to be considered as equivalent to the specific embodiments. The means and the materials to put into practice the different functions described herein could have a different nature without, for this reason, departing from the field of the invention. It is to be understood that the phraseology or terminology that is employed herein is for the purpose of description and not of limitation.

**Claims**

1. A probe head (30,50,60,70,80,90,100,101,130,130,131,150,151,160,180, 190,200) for NMR techniques, comprising:

    - an RF-coil (10) having a first conductor (11) and a second conductor (12,191) facing one another and arranged at a predetermined distance (L) from one another, so as to define a measurement zone (13) therebetween intended for arranging a sample (39) therein;
    - a connection conductor (16) electrically connecting respective end portions of said first conductor (11) and of said second conductor (12,191),

    said first conductor (11), said connection conductor (16) and said second conductor (12,191) made of a first material having a first magnetic susceptibility ($\chi_{m,ml}$);

    - an RF circuit (15) connected through an electric connection means (14) to said first conductor (11) and to said second conductor (12,191) opposite to said connection conductor (16), so that said first conductor (11), said connection conductor (16) and said second conductor (12) form a path (17) for an RF current ($I_{RF}$)

**characterized in that** in combination

- said first conductor (11) comprises linear conductor elements (9) arranged at such a mutual distance that said first conductor (11) is transparent to a microwave radiation (7) having a predetermined wavelength ($\lambda_{mw}$);
- said first conductor (11) and said second conductor (12) have lateral extensions (37,38,87,88,89,97,98,99,107,109,192,194,195) made of a second material having a second magnetic susceptibility ($\chi_{m,mII}$);
- said lateral extensions (37,38,87,88,89,97,98,99,107,109,192, 194,195) have a predetermined mass arranged to compensate a magnetic field distortion effect in said measurement zone (13).

2. A probe head according to claim 1, wherein the absolute values of said second magnetic susceptibility ($\chi_{m,mII}$) and of said first magnetic susceptibility ($\chi_{m,mI}$) differ by less than a predetermined difference value, in particular said first material is copper and said second material is Polyethylene Terephthalate, in particular said extension (37) of said first conductor is made of a material selected among PTFE, single-crystal quartz, sapphire, high-resistivity silicon.

3. A probe head according to claim 1, wherein said first conductor or said second conductor (11,12) extend along the direction of a first lateral dimension (I) and at least one of said lateral extensions (37,38) has a second lateral dimension (d) wherein said second lateral dimension (d) and said first lateral dimension (I) have a ratio higher than a predetermined value.

4. A probe head according to claim 1, wherein said lateral extensions (37,38) have substantially the same thickness ($t_1$, $t_2$).

5. A probe head according to claim 1, wherein at least one of said lateral extensions (37,38) have thicknesses ($t_1$,$t_2$) substantially the same as the thickness ($t_2$) of said second conductor (12).

6. A probe head (50,60,70,80,90,110) according to claim 1, comprising a further magnetic balancing extension (57,67) proximate to said connection conductor (16), wherein said further extension (57,67) is made of a third material having a third magnetic susceptibility ($\chi_{m,mIII}$) of opposite sign with respect to said first susceptibility ($\chi_{m,mI}$) of said first material, and is arranged to compensate a magnetic field distortion effect due to said connection conductor (16), in particular said further magnetic balancing extension is a magnetic balancing plate (57,67) arranged in contact with said connection conductor (16), in particular said connection conductor (16) and said magnetic balancing plate (57,67) have respective thicknesses ($d_I$, $d_{III}$) selected so as to satisfy the relationship: $d_I|\chi_{m,mI}| = d_{III}|\chi_{m,mIII}|$, in particular said magnetic balancing plate (67) has an at least in part curvilinear cross section, wherein said magnetic balancing plate (67) has a first flat face oriented towards said connection conductor (16) and a concave second side, opposite to said first face, with a higher thickness in a proximity (68,69) of said first and/or of said second conductor (11,12).

7. A probe head (60,70,80,90,110) according to claim 1, wherein said lateral extensions (37,38) of said first conductor (11) and of said second conductor (12) are made of materials (II,II') of respective magnetic susceptibilities ($\chi_{m,mII}$, $\chi_{m,mII'}$) and have respective thicknesses ($t_1$,$t_2$) selected so as to satisfy the relationship:

$$t_1\, \chi_{m,mII} = t_2\, \chi_{m,mII'}.$$

8. A probe head (60,70,80,90,110) according to claim 1, wherein said first conductor (11) and said second conductor (12) are made of materials (I,Ib) of respective magnetic susceptibilities ($\chi_{m,mI}$, $\chi_{m,mIb}$), and wherein said lateral extensions (37,38) of said first conductor (11) and of said second conductor (12) are made of materials (II,IIb) of respective magnetic susceptibilities ($\chi_{m,mII}$, $\chi_{m,mIIb}$) and have respective thicknesses ($t_1$, $t_2$) selected so as to satisfy the relationship:

$$t_1\, \chi_{m,mII} = t_2\, \chi_{m,mIIb}.$$

9. A probe head (80,90,100,101,130,130,131,150,151,160,170,180,190,200) according to claim 1, wherein said first conductor (11) and said second conductor (12) have respective pluralities ($N_1$, $N_2$) of lateral extensions in the form of layers (89,99,109,187) made of respective materials having respective predetermined magnetic susceptibilities ($\chi_{m,1,i}$; $\chi_{m,2}$, $_{l,l}$ = 1...$N_1$; i = 1...$N_2$),

in particular said layers (89,99,109) have respective thicknesses ($t_{1,i}$; $t_2$, $_{l,l}$ = 1 ...$m_1$; i = 1 ...$m_2$) selected so as to satisfy the following relationship:

$$t_{1,1}\chi_{m,1,1} + t_{1,2}\chi_{m,1,2} +_{...} = t_{2,1}\chi_{m,2,1} + t_{2,2}\chi_{m,2,2} +_{...}.$$

10. A probe head (80,90,100,101) according to claim 1, wherein an extension layer (89,99,109) of said second conductor (12) is arranged along said outer face of said second conductor (12) and of said extension (88,98) of said second conductor (12), said extension layer made of a material (IV) having a predetermined magnetic susceptibility ($\chi_{m,mIV}$) of opposite sign with respect to said magnetic susceptibilities ($\chi_{m,mI}$) of said first conductor (11) and of said second conductor (12),

in particular said extensions of said first conductor (11) and of said second conductor (12) and said further extension (89) have respective thicknesses ($t_1$, $t_{2,1}$, $t_{2,2}$) selected so as to satisfy the following relationship:

$$t_1 \chi_{m,mII} = t_{2,1} \chi_{m,mI} + t_{2,2} \chi_{m,mIV} = t_{2,1} \chi_{m,mI} - t_{2,2} |\chi_{m,mIV}|,$$

in particular said first conductor (11) is made of a material (V) having opposite sign with respect to said first first material of said RF-coil (10) in particular said extensions of said first conductor (11) and of said second conductor (12) and said further extension (89) have respective thicknesses ($t_1$, $t_{2,1}$, $t_{2,2}$) selected so as to satisfy the following relationship:

$$t_1 \chi_{m,mV} = t_{2,1} \chi_{m,mI} + t_{2,2} \chi_{m,mIV} = t_{2,1} \chi_{m,mI} - t_{2,2} |\chi_{m,mIV}|.$$

11. A probe head (130) according to claim 1, comprising a spacing element (137) made of a material having a magnetic susceptibility whose absolute value differs from the absolute value of said first magnetic susceptibility ($\chi_{m,mI}$) by less than a predetermined difference value, in particular said spacing element (137) is made of said second material.

12. A probe head (30,100,101,130,131,150,151,160,170,180,190) according to claim 1, wherein said lateral extensions (37) of said first conductor (11) comprise linear conductor elements (9) arranged at such a mutual distance that said lateral extensions (37) are transparent to said microwave radiation (7),

in particular said extension (87,97) of said first conductor (11) has substantially the same thickness ($t_2$) as said first conductor (11),

in particular said extension (107) of said first conductor (11) is made of a material of magnetic susceptibility of opposite sign with respect to the material of said linear conductor elements (9),

in particular said extension of said second conductor (12) comprises only said extension layer (109).

13. A probe head (160,170) according to claims 10 and 12, comprising a sample holder (161) wherein two layers are provided (162,163) connected to each other by connection elements (164,168,169) transversally arranged with respect to said layers (162,163), wherein said layers (162,163) and said connection elements (164,168,169) have such a thickness that said sample holder fits between said first conductor (11) and said second conductor (12), wherein said layers (162,163) are made of materials having a predetermined magnetic susceptibility, so as to obtain a balanced contribution to said static magnetic field ($B_0$) in said measurement zone (13).

in particular said layers (162,163) and said connection elements (164,168,169) define a plurality of chambers in said sample holder (161), in particular at least one of said chambers is configured to receive a liquid sample (165), in particular at least one of said chambers of said sample holder (161) is configured to receive an amount of a material (177) having a magnetic susceptibility that differs from the magnetic susceptibility of said sample by less than a predetermined difference value,

in particular said material (177) is a solvent for said sample (165), and said sample holder comprises flow passages through said separation elements (164,168,169) that are configured to selectively bring said solvent (177) into contact with said sample (165).

14. A probe head (190,200) according to claims 9 and 12, wherein said extension in the form of layer (187) has a thickness shorter than one tenth of said wavelength ($\lambda_{mw}$), said plurality ($N_1$) of lateral extensions in the form of layers of said first conductor (11), said layers having respective thicknesses $t_{1,j}$ and respective refraction indexes

$n_{1,j}$ with respect to said microwave radiation (7) has an overall optical thickness determined by the following relationship:

$$\tau_{1,\text{opt}} = \tau_{\text{w/s}} + t_{1,1}n_{1,1} + t_{1,2}n_{1,2} + \ldots = \tau_{\text{w/s}} + \sum_{j=1}^{N} t_{1,j}n_{1,j} \; ,$$

where $\tau_{\text{w/s}}$ is the contribution of the propagation through said linear conductor elements (9) of said first conductor (11), wherein $\tau_{1,\text{opt}}$ is about an integer multiple of one half of said wavelength ($\lambda_{\text{mw}}$).

15. A probe head (190,200) according to claim 12, comprising an electric heating means (193,191) configured to increase the temperature of said sample from a polarization temperature to a measurement temperature in a predetermined heating time,
in particular said electric heating means comprises an electrically conductive layer (193) configured to convey a heating electric current ($I_{ht}$), said electrically conductive layer (193) arranged between two layers (192,194) of at least one of said plurality of layers,
in particular said electric heating means comprises an electric supply means of said first conductor (191) configured to supply a heating electric current ($I_{ht}$) to said second conductor (191),
in particular said second conductor (191) has two different electric conductivity values along respective distinct electric current propagation directions, and said electric connection means (14) and said electric supply means of said second conductor (191) are configured to supply said RF and heating currents ($I_{RF}$, $I_{ht}$) along said electric current propagation directions of said second conductor (191),
in particular along two electric current propagation directions that are orthogonal to each other.

## Fig. 1A
*prior art*

## Fig. 1B
*prior art*

## Fig. 1C
*prior art*

## Fig. 2A
### *prior art*

## Fig. 2B
### *prior art*

**Fig. 3A**

**Fig. 3B**

**Fig. 3C**

## <u>Fig. 4</u>

# Fig. 5A

# Fig. 5B

## Fig. 6A

## Fig. 6B

## Fig. 7A

## Fig. 7B

## Fig. 8A

## Fig. 8B

# Fig. 9A

# Fig. 9B

# Fig. 10A

# Fig. 10B

# Fig. 11A

# Fig. 11B

# Fig. 12A

# Fig. 12B

# Fig. 13

## Fig. 14A

## Fig. 14B

## Fig. 14C

## Fig. 14D

## Fig. 14E

## Fig. 14F

# Fig. 15A

# Fig. 15B

# Fig. 15C

# Fig. 16

# Fig. 17

**Fig. 18A**

**Fig. 18B**

**EUROPEAN SEARCH REPORT**

Application Number

EP 19 17 6846

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 193 505 A2 (VARIAN INC [US]) 3 April 2002 (2002-04-03) * paragraph [0007] - paragraph [0016] * * paragraph [0020] * * figures 1-3B * | 1-15 | INV. G01N24/08 G01N24/10 G01N24/12 G01R33/28 G01R33/34 G01R33/565 |
| X | DE 10 2007 002440 A1 (UNIV CHEMNITZ TECH [DE]; UNIV LEIPZIG [DE]) 17 July 2008 (2008-07-17) * paragraph [0044] - paragraph [0058] * * figures 1, 2 * | 1-5,9,11 | |
| A | US 2012/068706 A1 (PRISNER THOMAS [DE] ET AL) 22 March 2012 (2012-03-22) * paragraph [0044] - paragraph [0060] * | 1-15 | |
| A | WO 2013/000508 A1 (CONSIGLIO NAZIONALE RICERCHE [IT]; ANNINO GIUSEPPE [IT]; MACOR ALESSAN) 3 January 2013 (2013-01-03) * the whole document * | 1-15 | |
| A,D | WO 2013/000964 A1 (CONSIGLIO NAZIONALE RICERCHE [IT]; ANNINO GIUSEPPE [IT]; MACOR ALESSAN) 3 January 2013 (2013-01-03) * the whole document * | 1-15 | TECHNICAL FIELDS SEARCHED (IPC) G01N G01R |

The present search report has been drawn up for all claims

| Place of search | Date of completion of the search | Examiner |
|---|---|---|
| Munich | 10 October 2019 | Streif, Jörg Ulrich |

**EP 3 572 804 A1**

## ANNEX TO THE EUROPEAN SEARCH REPORT
## ON EUROPEAN PATENT APPLICATION NO.

EP 19 17 6846

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2019

| Patent document cited in search report | | Publication date | Patent family member(s) | | Publication date |
|---|---|---|---|---|---|
| EP 1193505 | A2 | 03-04-2002 | DE | 60116211 T2 | 31-08-2006 |
| | | | DE | 60131386 T2 | 04-09-2008 |
| | | | EP | 1193505 A2 | 03-04-2002 |
| | | | EP | 1279967 A2 | 29-01-2003 |
| | | | JP | 4510344 B2 | 21-07-2010 |
| | | | JP | 2002162455 A | 07-06-2002 |
| | | | US | 6411092 B1 | 25-06-2002 |
| DE 102007002440 | A1 | 17-07-2008 | NONE | | |
| US 2012068706 | A1 | 22-03-2012 | EP | 2414820 A1 | 08-02-2012 |
| | | | US | 2012068706 A1 | 22-03-2012 |
| WO 2013000508 | A1 | 03-01-2013 | JP | 2014518384 A | 28-07-2014 |
| | | | US | 2014117988 A1 | 01-05-2014 |
| | | | WO | 2013000508 A1 | 03-01-2013 |
| | | | WO | 2013000964 A1 | 03-01-2013 |
| WO 2013000964 | A1 | 03-01-2013 | JP | 2014518384 A | 28-07-2014 |
| | | | US | 2014117988 A1 | 01-05-2014 |
| | | | WO | 2013000508 A1 | 03-01-2013 |
| | | | WO | 2013000964 A1 | 03-01-2013 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2013000964 A

- EP 1193505 A